# EUROPEAN PATENT SPECIFICATION

(11) **EP 1 669 195 B1**
(45) Date of publication and mention of the grant of the patent: **20.02.2008**
(21) Application number: 05027191.5
(22) Date of filing: 13.12.2005
(51) Int. Cl.: B41C 1/10

(54) **Lithographic printing method**
Flachdruckverfahren
Procédé d'impression lithographique

(30) Priority: 13.12.2004 JP 2004360135
(43) Date of publication of application: 14.06.2006
(73) Proprietor: FUJIFILM Corporation, Minato-ku Tokyo (JP)
(72) Inventor: Sonokawa, Koji, Yoshida-cho Haibara-gun Shizuoka (JP)
(74) Representative: HOFFMANN EITLE

(56) References cited:
- EP-A- 0 204 655
- EP-A- 1 462 249
- EP-A- 1 468 822
- GB-A- 1 542 475
- US-A- 5 562 031

## Description

### Background of the Invention

### 1. Field of the Invention

The present invention relates to a lithographic printing method using an on-press development type printing plate material, specifically relates to a lithographic printing method high in workability and productivity due to little contamination of water supply rollers by the components removed by on-press development and little paper loss of initial printing out.

### 2. Description of the Related Art

A so-called on-press development type printing plate material capable of development with a fountain solution and/or ink has so far been known as a means to improve the productivity of lithographic printing, since development process with a developing solution can be omitted, plate-making can be expedited and the production costs can be reduced due to the disuse of developing apparatus and developing solutions.

However, the method of development by using an on-press development type printing plate material with a fountain solution and/or ink is attended by the following drawback (refer to JP-A-2000-52634).

For example, in the on-press development type printing plate material of removing the image-recording layer of a non-image area, the image-recording layer of a non-image area is removed with a fountain solution and/or ink and a hydrophilic surface is bared after image recording, but there are cases where the image-recording layer is not completely removed and the residues of the image-recording layer adhere to the surface of the non-image area.

The area where the image-recording layer is adhered becomes lipophilic and ink is adhered, which results in contamination of the non-image area. The residues are removed by the fountain solution as printing advances and contamination is gradually vanished, but printing papers used after beginning of printing until vanishing of contamination are so-called lost papers and printed matters free of contamination cannot be obtained during that time.

Concerning this problem, the reduction of paper loss by initial printing out and shortening of time can be achieved by providing difference in the surface velocity between a printing plate material and a water application roller and/or ink application rollers and rubbing the surface of the printing plate material in supplying a fountain solution and/or ink to the image-recorded printing plate material on a plate cylinder by bringing the water application roller and/or ink application rollers into contact with the printing plate material (refer to JP-A-2004-284223).

However, in a on-press development type lithographic printing method performing development with a fountain solution and/or ink, if the area development processed with a water application roller is low in solubility in a fountain solution, there are cases where they adhere to the water application roller or other water supply rollers as development scum. The development scum cannot be cleaned even in roller washing at the end of printing work, so that manual work is required to wipe away the scum, which results in conspicuous reduction of workability and productivity. In particular, in the case where a fountain solution is supplied by a direct water supply method, the problem is serious because there is no destination of the components developed with the water application roller.

### Summary of the Invention

The present invention aims at solving this problem. That is, an object of the invention is to provide a lithographic printing method using an on-press development type printing plate material, by which the contamination of water supply rollers by the components removed by on-press development is little, the amount of paper loss of initial printing out is little, so that the time required until a printed matter free from contamination is obtained is short, and so workability and productivity are extremely high.

As a result of the investigation of a lithographic printing method using an on-press type printing plate material to achieve the above objects, the present inventor has found that water supply rollers are not contaminated by the components removed by on-press development and the reduction of paper loss by initial printing out and shortening of time can be achieved by oscillating the roller contiguous to a water application roller in the axial direction of the roller in supplying a fountain solution to an image-recorded printing plate material on a plate cylinder by bringing the water application roller into contact with the printing plate material, thus the present invention has been achieved.

That is, the present invention is as follows.
(1) A lithographic printing method comprising:
   (i) a process of one of (i-1) imagewise exposing a lithographic printing plate precursor comprising a support and an image-recording layer capable of being removed with at least one of a fountain solution and a printing ink, and mounting the exposed printing plate precursor on a plate cylinder of a printing press; and (ii-2) mounting the lithographic printing plate precursor on a plate cylinder of a printing press and imagewise exposing the lithographic printing plate precursor;
   (ii) a process of removing an unexposed area of the image-recording layer by directly supplying a fountain solution on the exposed lithographic printing plate precursor with a water application roller of the printing press (i.e., with a direct water supply method in which the fountain solution is not mixed with other substances before being supplied on the exposed lithographic printing plate precursor); and
   (iii) a process of printing,
   wherein the printing press comprises a water supply apparatus including a water application roller and at least one roller in contact with the water application roller, at least one of said at least one roller being an oscillating roller capable of revolving while oscillating in its axial direction.
(2) The lithographic printing method as described in the above item (1), wherein the image-recording layer contains (A) an infrared absorber, (B) a polymerization initiator, (C) a polymerizable compound, and (D) a lipophilic binder polymer, and the exposure light source is an infrared laser.
(3) The lithographic printing method as described in the above item (1), wherein the image-recording layer contains (B) a polymerization initiator, (C) a polymerizable compound, and (D) a lipophilic binder polymer, has photosensitivity in the range of the wavelength of from 250 to 420 nm, and the exposure light source is an ultraviolet laser.
(4) The lithographic printing method as described in the above item (1), (2) or (3), wherein the water application roller is in contact with at least one roller having a surface linear velocity different from that of the water application roller.
(5) The lithographic printing method as described in any of the above items (1) to (4), wherein the surface linear velocity of the water application roller is different from the surface linear velocity of the plate cylinder.
(6) The lithographic printing method as described in any one of the above items (1) to (5), wherein the oscillation width of at least one oscillating roller adjacent to the water application roller is 10 mm or more.
(7) The lithographic printing method as described in any of the above items (1) to (6), wherein the image-recording layer contains microcapsules or microgel.

In the development process in the invention, by using an oscillating roller as at least one roller in contact with a water application roller, the water supply rollers were not contaminated by the components removed by on-press development, and the reduction of paper loss by initial printing out and shortening of time could be achieved.

As the mechanism of the function, it is thought that the components removed by development are easily finely dispersed by the rubbing function between the water application roller and the oscillating roller brought about by the oscillation of the oscillating roller in the axial direction of the roller, as a result the components do not adhere to the water application roller and other water supply rollers as development scum and do not accumulate on the water application roller, so that on-press developability does not deteriorate and the contamination of the non-image area after beginning of printing can be cleaned in an extremely short time.

Also, it is thought that when the surface linear velocity of the water application roller and that of at least one roller in contact with the water application roller or the plate cylinder are different, the effect of finely dispersing the components removed by development is further great due to the rubbing function between them.

Further, since the image-recording layers in the above items (4) to (6) are excellent in developability and fine dispersibility on the water application roller, good on-press developability can be obtained and the contamination of the water supply rollers can be prevented, as a result it becomes possible to secure superior workability and productivity, and high quality printed matters can be obtained.

### Brief Description of the Drawings

Fig. 1 is a conceptual drawing of Epic Delta water supply apparatus.
Fig. 2 is a conceptual drawing of Alcolor water supply apparatus.
Fig. 3 is a conceptual drawing of Komorimatic water supply apparatus.

10 denotes a plate cylinder; 20 denotes a water supply roller; 21 denotes a water application roller; 22 denotes a roller for supplying water to water application roller; 23 denotes a water source roller; 24 denotes a roller for stabilizing water amount; 25 denotes a roller array; 30 denotes an ink roller; 31 denotes an ink application roller; 32 denotes a kneading roller; 40 denotes a bridge roller; and 50 denotes a water boat

### Detailed Description of the Invention

The lithographic printing method and a lithographic printing plate precursor for use in the lithographic printing method are described in detail below.

### Lithographic Printing Method:

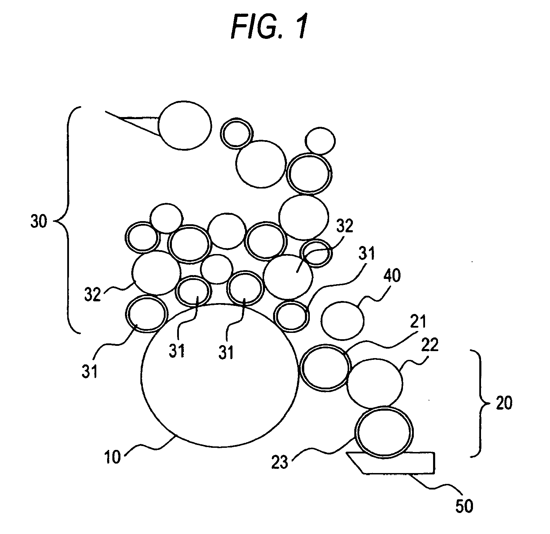

In the first place, the water supply apparatus of the printing press usable in the lithographic printing method in the invention are explained. Figs. 1 to 3 are conceptual drawings of the examples of water supply apparatus that can be used in the lithographic printing method of the invention.

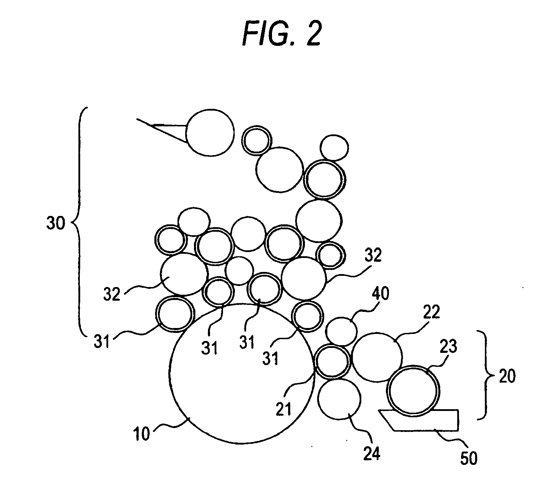

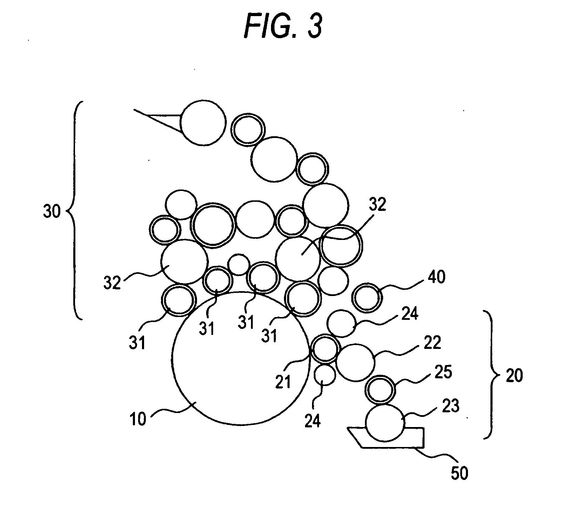

The water supply apparatus shown in Fig. 1 is Epic Delta water supply apparatus, the water supply apparatus shown in Fig. 2 is Alcolor water supply apparatus, and the water supply apparatus shown in Fig. 3 is Komorimatic water supply apparatus. Each water supply apparatus is equipped with, as water supply rollers, water application roller 21 in contact with plate cylinder 10, roller 22 that is in contact with water application roller 21 and supplies a fountain solution from water boat 50 to water application roller 21, and water source roller 23 that is soaked in water boat 50 holding a fountain solution. In some case, the water supply apparatus have roller 24 in contact with water application roller 21 for stabilizing the water amount on water application roller 21. Roller 24 is called a distribution roller or a rider roller in accordance with the water supply method. Further, in accordance with water supply methods, there is a case where roller array 25 is further provided between roller 22 and water source roller 23. Water supply apparatus may have bridge roller 40 capable of taking a direct water supply method by bridging ink rollers 30 comprising ink application roller 31 and kneading roller 32 provided thereon and water supply rollers 20.

However, in the lithographic printing method in the invention, water is supplied by a direct water supply method for bridge roller 40 not to be in contact with at least either water supply rollers 20 or ink rollers 30.

In the lithographic printing method in the invention, an on-press development type printing plate material is mounted on plate cylinder 10 of a printing press in the first place. The printing plate material may have been exposed in advance, or may be exposed on plate cylinder 10 after mounting if the printing press for use in the invention is equipped with an exposure apparatus.

In the next place, a fountain solution is supplied by driving the water supply apparatus from water boat 50 to water source roller 23, in cases through roller array 25 and roller 22, and to water application roller 21 in order, to thereby supply the fountain solution to the printing plate material by getting water application roller 21 into contact with the printing plate material in this state. Thus, the non-image area of the image-recording layer of the printing plate material is developed by the dissolving function of the fountain solution itself and/or the dispersion function and rubbing function.

After that, ink is supplied from ink application roller 31 to the printing plate material, and the ink on the printing plate material is transferred to a blanket by impression and further transferred to a printing medium, e.g., printing paper.

In the invention, (ii) on-press development process and (iii) printing process of supplying ink from ink application roller 31 to the printing plate material and impression can also be carried out at the same time.

In the lithographic printing method in the invention, in the above processes, it is essential that the supply method of a fountain solution is a direct supply method, and at least one roller in contact with the water application roller is an oscillating roller. That is, roller 22 and roller 24 in Figs. 1 to 3 are essential to revolve while oscillating in the axial direction of the rollers. Also, as shown in Fig. 2, in the case where bridge roller 40 is apart from ink roller 30 and in contact with water application roller 21, it is sufficient that bridge roller 40 is oscillating.

The number of oscillating rollers in contact with water application roller 21 is preferably many.

The amplitude (magnitude of fluctuation) and cycle of oscillation are not especially restricted, but the amplitude is preferably in the range of from 1 to 100 mm, more preferably from 5 to 50 mm, most preferably 10 mm or more, and the cycle of oscillation is preferably in the range of from 0.1 to 10 seconds, and more preferably from 0.5 to 5 seconds.

As more preferred embodiment of the lithographic printing method in the invention, it is preferred that at least one roller of these rollers in contact with water application roller 21 is revolving at a surface linear velocity different from the surface linear velocity of water application roller 21.

To make surface linear velocities different is possible by means of driving respective rollers with respective driving systems, and a means of driving with the same driving system but by different gear ratios. It can also be achieved by connecting water application roller 21 with a roller having a different surface linear velocity via different gear ratio from the roller diameter ratio.

A roller in contact with water application roller 21 and having different surface linear velocity may be the same roller as the above oscillating roller or may be a different roller.

The number of rollers in contact with water application roller 21 and having different surface linear velocity is preferably many.

The velocity ratio of the surface linear velocity of a roller having different surface linear velocity to the surface linear velocity of water application roller 21 is preferably not the same velocity and is not especially restricted, but the velocity ratio is preferably in the range of from+0.01% to +50%, or from -0.01% to -50%, to the surface linear velocity of the water application roller, more preferably in the range of from +0.1% to +20%, or -0. 1% to -20%.

In more preferred embodiment of the invention, it is preferred that the surface linear velocity of water application roller 21 is different from the printing plate linear velocity on plate cylinder 10.

The velocity ratio of the surface linear velocity of water application roller 21 to the printing plate linear velocity, so-called slip ratio, is not particularly restricted provided that the velocities are not the same. The velocity ratio is preferably in the range of from +0.01% to +50%, or from -0.01% to -50%, to the linear velocity of the printing plate, more preferably in the range of from +0.1% to +20%, or -0.1 % to -20%.

The lithographic printing method according to the invention has been described with reference to the accompanying drawings showing preferred embodiments of the invention, the invention is, however, not restricted thereto and various changes and modifications can be made therein without departing from the spirit and scope thereof. For example, other water supply methods not shown, e.g., Rolandmatic, Diamatic and Ryobimatic, can also be preferably used, and the constitution of each part can be replaced with the arbitrary constitution capable of showing similar performances.

In the lithographic printing method in the invention, imagewise exposure is carried out in the process of the above (i). As the exposure light source, a laser is preferred. The lasers for use in the invention are not especially restricted, but solid state lasers and semiconductor lasers radiating infrared rays of the wavelength of from 760 to 1,200 nm, and semiconductor lasers radiating the rays of from 250 to 420 nm are preferably exemplified.

Infrared lasers showing output of 100 mW or more are preferred, the exposure time per a pixel is preferably less than 20 µsec, and the quantity of radiating energy is preferably from 10 to 300 mJ/cm². In semiconductor lasers radiating the rays of from 250 to 420 nm, the output is preferably 0.1 mW or more. In any lasers, multi-beam laser devices are preferably used for shortening exposure time.

An exposed lithographic printing plate precursor is mounted on the plate cylinder of a printing press. In the case of a printing press equipped with a laser exposure apparatus, a lithographic printing plate precursor is imagewise exposed after being mounted on the plate cylinder of a printing press.

In the present invention, at the same time with process (ii), processing may continuously advance to printing of process (iii) by bringing an ink application roller into contact with a plate cylinder and a blanket with the plate cylinder respectively, and passing printing papers. That is, process (ii) and process (iii) may be one and the same process.

For example, in one embodiment of a negative on-press development type lithographic printing plate precursor, when a lithographic printing plate precursor imagewise exposed with a laser is supplied with a fountain solution and inks without being subjected to development process such as wet development process and used for printing, an image-recording layer cured by exposure forms a printing ink receptive area having a lipophilic surface in the exposed area of the image-recording layer. On the other hand, in the unexposed area, an uncured image-recording layer is dissolved or dispersed and removed by the supplied fountain solution and/or printing inks and a hydrophilic surface is bared at that area. As a result, the fountain solution is adhered to the bared hydrophilic surface, and printing inks are adhered to the image-recording layer in the exposed area, thus printing begins.

A lithographic printing plate precursor is on-press developed on an offset press in this manner and continuously used for printing of a large number of sheets of paper.

### Lithographic Printing Plate Precursor:

The elements and components constituting the lithographic printing plate precursor in the invention are explained in detail below.

### Image-Recording Layer:

The image-recording layer in the invention is removable with a fountain solution and/or printing ink and contains (B) a polymerization initiator, (C) a polymerizable compound, and (D) a lipophilic binder polymer.

Further, as the image-recording layer in the invention, image-recording layers containing (A) an infrared absorber and capable of image recording with infrared lasers, or those having photosensitivity in the range of from 250 to 420 nm and capable of recording with ultraviolet lasers are preferred.

### (A) Infrared Absorber:

When image recording is performed with infrared lasers, the image-recording layer in the invention contains infrared absorbers for increasing sensitivity to infrared lasers. Infrared absorbers have a function to convert absorbed infrared rays to heat. Infrared absorbers fore use in the invention are dyes or pigments having an absorption maximum in the wavelength region of from 760 to 1,200 nm.

As the dyes, commercially available dyes and well-known dyes described in literatures, e.g., Senryo Binran (Dye Handbook), compiled by Yuki Gosei Kagaku Kyokai (1970) can be used. Specifically, azo dyes, metal complex azo dyes, pyrazolone azo dyes, naphthoquinone dyes, anthraquinone dyes, phthalocyanine dyes, carbonium dyes, quinoneimine dyes, methine dyes, cyanine dyes, squarylium dyes, pyrylium salts and metal thiolate complexes are exemplified.

As preferred dyes, e.g., the cyanine dyes disclosed in JP-A-58-125246, JP-A-59-84356 and JP-A-60-78787, the methine dyes disclosed in JP-A-58-173696, JP-A-58-181690 and JP-A-58- 194595, the naphthoquinone dyes disclosed in JP-A-58-112793, JP-A-58-224793, JP-A-59-48187, JP-A-59-73996, JP-A-60-52940 and JP-A-60-63744, the squarylium dyes disclosed in JP-A-58- 112792, and the cyanine dyes disclosed in British Patent 434,875 are exemplified.

Further, the near infrared absorbing sensitizers disclosed in U.S. Patent 5,156,938 are also preferably used, in addition, the substituted arylbenzo(thio)pyrylium salts disclosed in U.S. Patent 3,881,924, the trimethine thiapyrylium salts disclosed in JP-A-57-142645 (corresponding to U.S. Patent 4,327,169), the pyrylium-based compounds disclosed in JP-A-58-181051, JP-A-58-220143, JP-A-59-41363, JP-A-59-84248, JP-A-59-84249, JP-A-59-146063 and JP-A-59- 146061, the cyanine dyes disclosed in JP-A-59-216146, the pentamethine thiopyrylium salts disclosed in U.S. Patent 4,283,475, and the pyrylium compounds disclosed in JP-B-5- 13514 (the term "JP-B" as used herein refers to an "examined Japanese patent publication") and JP-B-5-19702 are also preferably used in the invention. As other examples of preferred dyes, the near infrared absorbing dyes represented by formulae (I) and (II) disclosed in U.S. Patent 4,756,993 can be exemplified.

As other preferred examples of infrared absorbing dyes in the invention, the specific indolenine cyanine dyes disclosed in JP-A-2002-278057 as shown below can be exemplified.

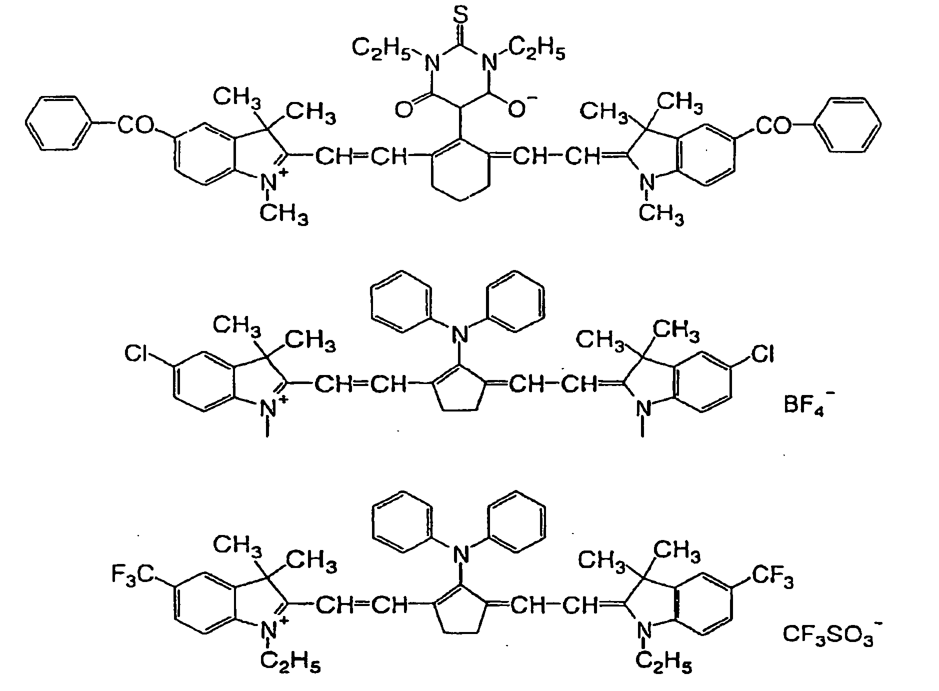

Of these dyes, cyanine dyes, squarylium dyes, pyrylium salts, nickel thiolate complexes and indolenine cyanine dyes are exemplified as particularly preferred dyes. Cyanine dyes and indolenine cyanine dyes are more preferred, and as one particularly preferred example, a cyanine dye represented by the following formula (I) is exemplified.

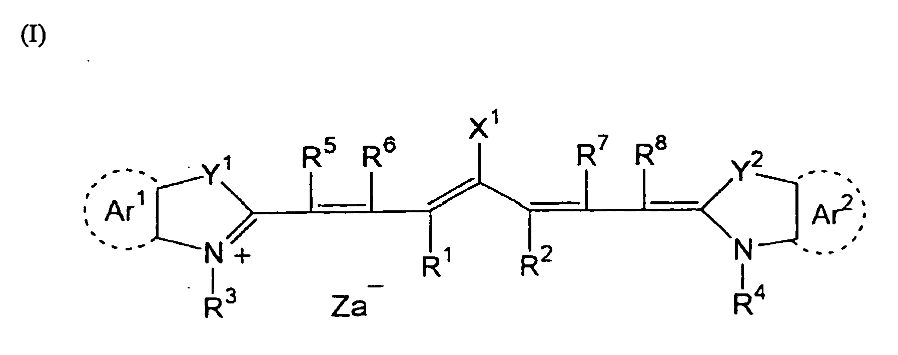

In formula (I), X¹ represents a hydrogen atom, a halogen atom, -NPh₂, X²-L¹, or a group shown below. 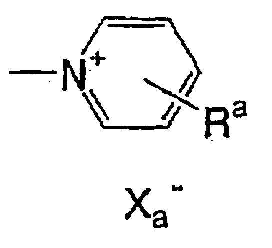 wherein Xₐ⁻ is defined the same as the later-described Zₐ⁻, R^{a} represents a substituent selected from among a hydrogen atom, an alkyl group, an aryl group, a substituted or unsubstituted amino group and a halogen atom.

X² represents an oxygen atom, a nitrogen atom or a sulfur atom; L¹ represents a hydrocarbon group having from 1 to 12 carbon atoms, an aromatic ring having a hetero atom, or a hydrocarbon group containing a hetero atom having from 1 to 12 carbon atoms. The hetero atoms here mean N, S, O, a halogen atom and Se.

In formula (I), R¹ and R² each represents a hydrocarbon group having from 1 to 12 carbon atoms. In view of the preservation stability of the recording layer coating solution, R¹ and R² each preferably represents a hydrocarbon group having 2 or more carbon atoms, and especially preferably R¹ and R² are bonded to each other to form a 5- or 6-membered ring.

Ar¹ and Ar², which may be the same or different, each represents an aromatic hydrocarbon group which may have a substituent. The examples of preferred aromatic hydrocarbon groups include a benzene ring and a naphthalene ring. The preferred examples of the substituents include a hydrocarbon group having 12 or less carbon atoms, a halogen atom, and an alkoxyl group having 12 or less carbon atoms. Y¹ and Y², which may be the same or different, each represents a sulfur atom or a dialkylmethylene group having 12 or less carbon atoms. R³ and R⁴, which may be the same or different, each represents a hydrocarbon group having 20 or less carbon atoms which may have a substituent. The preferred substituents include an alkoxyl group having 12 or less carbon atoms, a carboxyl group and a sulfo group. R⁵, R⁶, R⁷ and R⁸, which may be the same or different, each represents a hydrogen atom or a hydrocarbon group having 12 or less carbon atoms, preferably a hydrogen atom because of easy availability of the material. Zₐ⁻represents a counter anion, however when a cyanine dye represented by formula (I) has an anionic substituent within the structure and the neutralization of the electric charge is not necessary, Zₐ⁻ is not necessary. Zₐ⁻ preferably represents a halogen ion, a perchlorate ion, a tetrafluoro- borate ion, a hexafluorophosphate ion or a sulfonate ion for the preservation stability of the recording layer coating solution, and Zₐ⁻ particularly preferably represents a perchlorate ion, a hexafluorophosphate ion or an arylsulfonate ion.

As the specific examples of the cyanine dyes represented by formula (I) that can be preferably used in the invention, the cyanine dyes disclosed in JP-A-2001-133969, paragraphs [0017] to [0019] are exemplified.

Further, as particularly preferred other examples of infrared absorbers, the specific indolenine cyanine dyes disclosed in JP-A-2002-278057 are exemplified.

As the pigments for use in the present invention, commercially available pigments and the pigments described in Color Index (C.I.) Binran (Color Index Bulletin), Shaishin Ganryo Binran (The Latest Pigment Handbook), compiled by Nippon Ganryo Gijutsu Kyokai (1977), Shaishin Ganryo Oyo Gijutsu (The Latest Pigment Applied Techniques), CMC Publishing Co. Ltd. (1986), and Insatsu Ink Gijutsu (printing Ink Techniques), CMC Publishing Co. Ltd. (1984) can be exemplified.

Various kinds of pigments can be used in the invention, e.g., black pigments, yellow pigments, orange pigments, brown pigments, red pigments, purple pigments, blue pigments, green pigments, fluorescent pigments, metallic powder pigments, and polymer-bond pigments can be exemplified. Specifically, insoluble azo pigments, azo lake pigments, condensation azo pigments, chelate azo pigments, phthalocyanine pigments, anthraquinone pigments, perylene and perinone pigments, thioindigo pigments, quinacridone pigments, dioxazine pigments, isoindolinone pigments, quinophthalone pigments, in-mold lake pigments, azine pigments, nitroso pigments, nitro pigments, natural pigments, fluorescent pigments, inorganic pigments, and carbon black can be used. Of these pigments, carbon black is preferably used.

These pigments can be used without surface treatment or may be subjected to surface treatment. As the methods of surface treatments, a method of coating the surfaces of pigments with resins and waxes, a method of adhering surfactants, and a method of bonding reactive substances (e.g., a silane coupling agent, an epoxy compound, or polyisocyanate) on the surfaces of pigments can be exemplified. These surface treatment methods are described in Kinzoku Sekken no Seishitsu to Oyo (Natures and Applications of Metal Soaps), Saiwai Shobo, Insatsu Ink Gijutsu (Printing Ink Techniques), CMC Publishing Co., Ltd. (1984), and Shaishin Ganryo Oyo Gijutsu (The Latest Pigment Applied Techniques), CMC Publishing Co., Ltd. (1986).

The particle size of pigments is preferably from 0.01 to 10 µm, more preferably from 0.05 to 1 µm, and especially preferably from 0.1 to 1 µm. When the particle size of pigments is in this range, stability of the pigment dispersion in an image-recording layer coating solution and uniformity of an image-recording layer can be obtained.

Well-know dispersing techniques used in the manufacture of inks and toners can be used as the dispersing method of pigments in the invention. The examples of dispersing apparatus include an ultrasonic disperser, a sand mill, an attritor, a pearl mill, a super-mill, a ball mill, an impeller, a disperser, a KD mill, a colloid mill, a dynatron, a three-roll mill and a pressure kneader, and details thereof are described in Shaishin Ganryo Oyo Gijutsu (The Latest Pigment Application Techniques), CMC Publishing Co., Ltd. (1986).

These infrared absorbers may be added to the same layer with other components, may be added to a discoloring layer, or a separate layer may be provided and added thereto. Alternatively, infrared absorbers may be added as the form of being encapsulated in microcapsules.

When a negative lithographic printing plate precursor is prepared, it is preferred that infrared absorbers are added so that the absorbance of an image-recording layer at the maximum absorption wavelength in the wavelength range of from 760 to 1,200 nm is from 0.3 to 1.2 by a reflection measuring method, more preferably from 0.4 to 1.1. In this range of the addition amount, the polymerization reaction proceeds uniformly in the depth direction of the image-recording layer and good layer strength of the image area and sufficient adhesion to the support can be obtained.

The absorbance of an image-recording layer can be adjusted by the addition amount of an infrared absorber to the image-recording layer and the thickness of the image-recording layer. Absorbance can be measured by ordinary methods, e.g., a method of forming an image-recording layer having an arbitrarily determined thickness in a dry coating weight necessary as the lithographic printing plate on a reflective support, such as an aluminum support, and measuring the reflection density with an optical densitometer, and a method of measuring the absorbance by a reflection method using an integrating sphere with a spectrophotometer are exemplified.

### (B) Polymerization Initiator

A polymerization initiator that can be used in the invention is a compound capable of generating a radical by light or heat energy and initiating and accelerating polymerization of a compound having a polymerizable unsaturated group. Such radical polymerization initiators can be arbitrarily selected and used from well known polymerization initiators and compounds having small bond-dissociating energy.

As such radical-generating compounds, e.g., organic halogen compounds, carbonyl compounds, organic peroxides, azo-based polymerization initiators, azide compounds, metallocene compounds, hexaarylbiimidazole compounds, organic boron compounds, disulfone compounds, oxime ester compounds, and onium salt compounds are exemplified.

As the organic halogen compounds, specifically, the compounds described in Wakabayashi et al., Bull. Chem. Soc. Japan, 42, 2924 (1969), U.S. Patent 3,905,815, JP-B-46-4605, JP-A-48-36281, JP-A-53-133428, JP-A-55-32070, JP-A-60-239736, JP-A-61-169835, JP-A-61-169837, JP-A-62-58241, JP-A-62- 212401, JP-A-63-70243, JP-A-63-298339, and M.P. Hutt, Journal of Heterocyclic Chemistry, 1 (No. 3) (1970) are exemplified. Of these compounds, oxazole compounds substituted with a trihalomethyl group and s-triazine compounds are preferably used.

More preferably, s-triazine derivatives and oxadiazole derivatives in which at least one mono-, di- or tri-halogen- substituted methyl group is bonded to the s-triazine ring, and the oxadiazole ring respectively can be exemplified. Specifically, e.g., 2,4,6-tris(monochloromethyl)-s-triazine, 2,4,6-tris(dichloromethyl)-s-triazine, 2,4,6-tris-(trichloromethyl)-s-triazine, 2-methyl-4,6-bis(trichloro- methyl)-s-triazine, 2-n-propyl-4,6-bis(trichloromethyl)- s-triazine, 2-(α,α,β-trichloroethyl)-4,6-bis(trichloromethyl)-s-triazine, 2-(3,4-epoxyphenyl)-4,6-bis(trichloro- methyl)-s-triazine, 2-[1-(p-methoxyphenyl)-2,4-butadienyl]- 4,6-bis(trichloromethyl)-s-triazine, 2-styryl-4,6-bis- (trichloromethyl)-s-triazine, 2-(p-methoxystyryl)-4,6-bis-(trichloromethyl)-s-triazine, 2-(p-i-propyloxystyryl)-4,6- bis(trichloromethyl)-s-triazine, 2-(p-tolyl)-4,6-bis- (trichloromethyl)-s-triazine, 2-(4-methoxynaphthyl)-4,6-bis(trichloromethyl)-s-triazine, 2-phenylthio-4,6-bis- (trichloromethyl)-s-triazine, 2-benzylthio-4,6-bis- (trichloromethyl)-s-triazine, 2,4,6-tris(dibromomethyl)- s-triazine, 2,4,6-tris(tribromomethyl)-s-triazine, 2- methyl-4,6-bis(tribromomethyl)-s-triazine, and 2-methoxy- 4,6-bis(tribromomethyl)-s-triazine and the following compounds are exemplified.

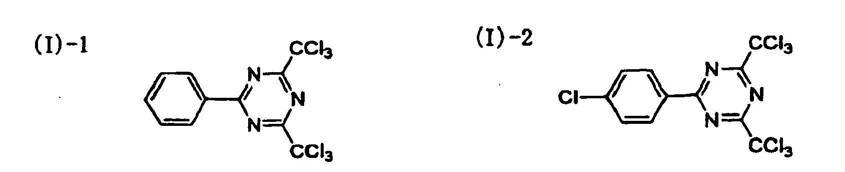

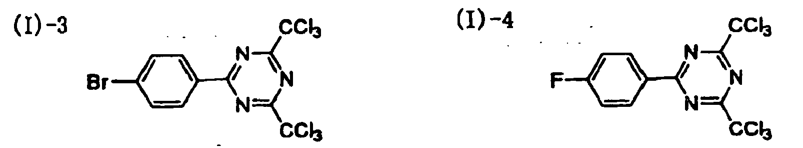

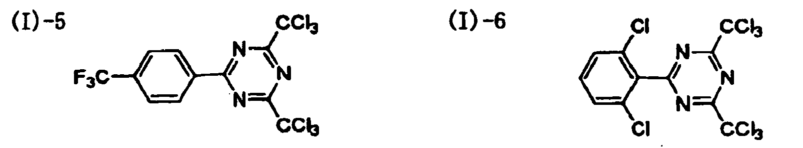

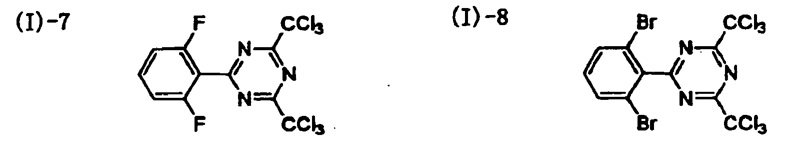

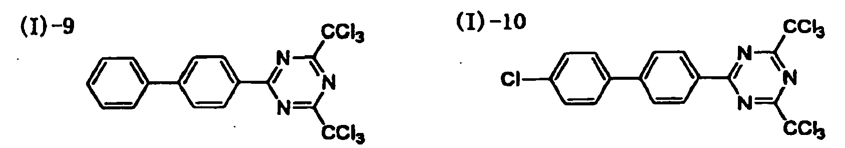

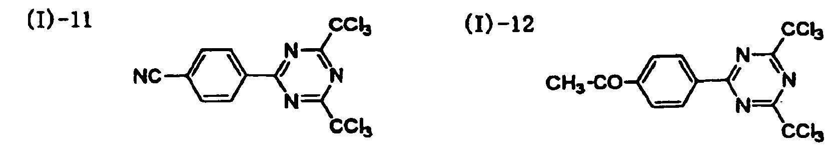

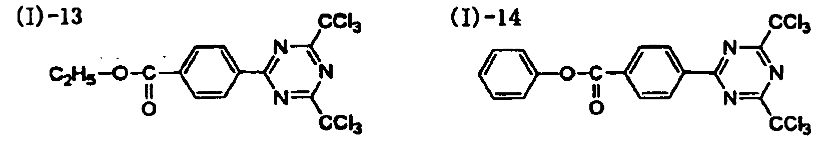

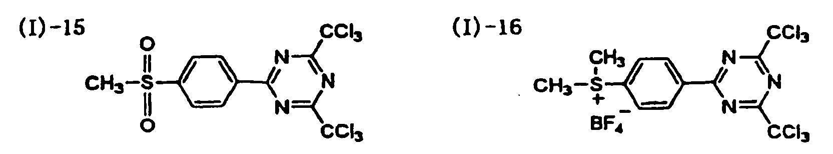

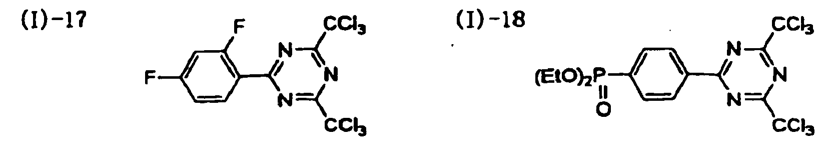

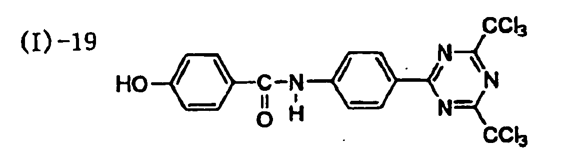

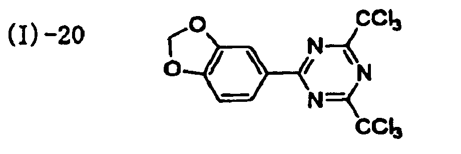

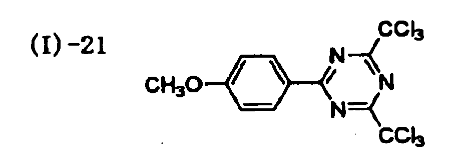

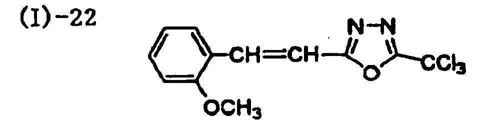

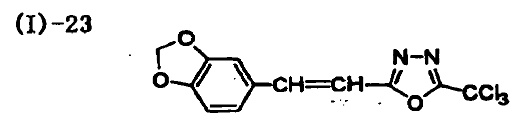

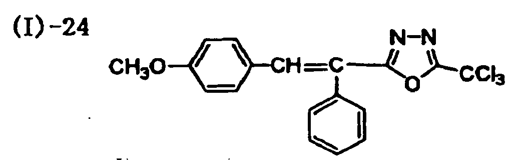

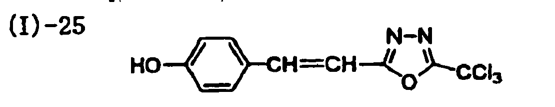

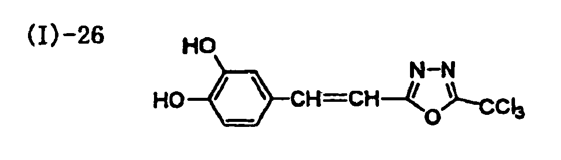

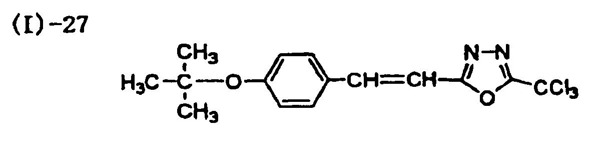

As the carbonyl compounds, benzophenone derivatives, e.g., benzophenone, Michler's ketone, 2-methylbenzophenone, 3-methylbenzophenone, 4-methylbenzophenone, 2-chlorobenzo- phenone, 4-bromobenzophenone, and 2-carboxybenzophenone, acetophenone derivatives, e.g., 2,2-dimethoxy-2-phenyl- acetophenone, 2,2-diethoxyacetophenone, 1-hydroxycyclohexyl phenyl ketone, α-hydroxy-2-methylphenylpropanone, 1-hydroxy- 1-methylethyl-(p-isopropylphenyl) ketone, 1-hydroxy-1-(p- dodecylphenyl) ketone, 2-methyl-[4'-(methylthio)phenyl]-2-morpholino-1-propanone, and 1,1,1-trichloromethyl-(p-butyl- phenyl) ketone, thioxanthone derivatives, e.g., thioxanthone, 2-ethylthioxanthone, 2-isopropylthioxanthone, 2-chloro-thioxanthone, 2,4-dimethylthioxanthone, 2,4-diethylthio- xanthone, and 2,4-diisopropylthioxanthone, and benzoic ester derivatives, e.g., ethyl p-dimethylaminobenzoate and ethyl p-diethylaminobenzoate are exemplified.

As the azo compounds, e.g., the azo compounds disclosed in JP-A-8-108621 are exemplified.

As the organic peroxides, e.g., trimethylcyclohexanone peroxide, acetylacetone peroxide, 1,1-bis(tert-butylperoxy)- 3,3,5-trimethylcyclohexane, 1,1-bis(tert-butylperoxy)cyclo- hexane, 2,2-bis(tert-butylperoxy)butane, tert-butyl hydroperoxide, cumene hydroperoxide, diisopropylbenzene hydro- peroxide, 2,5-dimethylhexane-2,5-dihydroperoxide, 1,1,3,3- tetramethylbutyl hydroperoxide, tert-butylcumyl peroxide, dicumyl peroxide, 2,5-dimethyl-2,5-di(tert-butylperoxy)- hexane, 2,5-oxanoyl peroxide, succinic acid peroxide, benzoyl peroxide, 2,4-dichlorobenzoyl peroxide, diisopropylperoxy dicarbonate, di-2-ethylhexylperoxy dicarbonate, di-2-ethoxy-ethylperoxy dicarbonate, dimethoxyisopropylperoxy carbonate, di(3-methyl-3-methoxybutyl)peroxy dicarbonate, tert-butyl- peroxy acetate, tert-butylperoxy pivalate, tert-butylperoxy neodecanoate, tert-butylperoxy octanoate, tert-butylperoxy laurate, tersyl carbonate, 3,3',4,4'-tetra(t-butylperoxy-carbonyl)benzophenone, 3,3',4,4'-tetra(t-hexylperoxy- carbonyl)benzophenone, 3,3',4,4'-tetra(p-isopropylcumyl- peroxycarbonyl)benzophenone, carbonyldi(t-butylperoxy-dihydrogendiphthalate), and carbonyldi(t-hexylperoxy- dihydrogendiphthalate) are exemplified.

As the metallocene compounds, various titanocene compounds disclosed in JP-A-59-152396, JP-A-61-151197, JP-A-63-41484, JP-A-2-249, JP-A-2-4705 and JP-A-5-83588, e.g., dicyclopentadienyl-Ti-bis-phenyl, dicyclopentadienyl-Ti-bis-2,6-difluorophen-1-yl, dicyclopentadienyl-Ti-bis- 2,4-difluorophen-1-yl, dicyclopentadienyl-Ti-bis-2,4,6- trifluorophen-1-yl, dicyclopentadienyl-Ti-bis-2,3,5,6-tetrafluorophen-1-yl, dicyclopentadienyl-Ti-bis-2,3,4,5,6- pentafluorophen-1-yl, dimethylcyclopentadienyl-Ti-bis-2,6- difluorophen-1-yl, dimethylcyclopentadienyl-Ti-bis-2,4,6- trifluorophen-1-yl, dimethylcyclopentadienyl-Ti-bis- 2,3,5,6-tetrafluorophen-1-yl, dimethylcyclopentadienyl-Ti- bis-2,3,4,5,6-pentafluorophen-1-yl, and the iron-arene complexes disclosed in JP-A-1-304453 and JP-A-1-152109 are exemplified.

As the hexaarylbiimidazole compounds, various compounds disclosed in JP-B-6-29285, U.S. Patents 3,479,185, 4,311,783 and 4,622,286, specifically, e.g., 2,2'-bis(o-chlorophenyl)- 4,4',5,5'-tetraphenylbiimidazole, 2,2'-bis(o-bromophenyl)-4,4',5,5'-tetraphenylbiimidazole, 2,2'-bis(o,p-dichlorophenyl)-4,4',5,5'-tetraphenylbiimidazole, 2,2'-bis-(o-chlorophenyl)-4,4',5,5'-tetra(m-methoxyphenyl)biimidazole, 2,2'-bis(o,o'-dichlorophenyl)-4,4',5,5'-tetraphenyl- biimidazole, 2,2'-bis(o-nitrophenyl)-4,4',5,5'-tetraphenyl- biimidazole, 2,2'-bis(o-methylphenyl)-4,4',5,5'-tetra- phenylbiimidazole, and 2,2'-bis(o-trifluorophenyl)- 4,4',5,5'-tetraphenylbiimidazole are exemplified.

As the organic boron compounds, e.g., the organic borates disclosed in JP-A-62-143044, JP-A-62-150242, JP-A-9-188685, JP-A-9-188686, JP-A-9-188710, JP-A-2000-131837, JP-A-2002- 107916, Japanese Patent No. 2764769, JP-A-2002-116539, and Kunz, Martin, "Rad Tech '98 Proceeding April 19-22, 1998, Chicago", the organic boron sulfonium complexes or the organic boron oxosulfonium complexes disclosed in JP-A-6-157623, JP-A-6-175564 and JP-A-6-175561, the organic boron iodonium complexes disclosed in JP-A-6-175554 and JP-A-6-175553, the organic boron phosphonium complexes disclosed in JP-A-9- 188710, and organic boron transition metal coordination complexes disclosed in JP-A-6-348011, JP-A-7-128785, JP-A-7- 140589, JP-A-7-306527 and JP-A-7-292014 are exemplified.

As the disulfone compounds, the compounds disclosed in JP-A-61-166544 and JP-A-2003-328465 are exemplified.

As the oxime ester compounds, the compounds described in J.C.S. Perkin II, 1653-1660 (1979), J.C.S. Perkin II, 156-162 (1979), Journal of Photopolymer Science and Technology, 202-232 (1995), JP-A-2000-66385, the compounds disclosed in JP-A-2000-80068, specifically the compounds represented by the following formulae are exemplified.

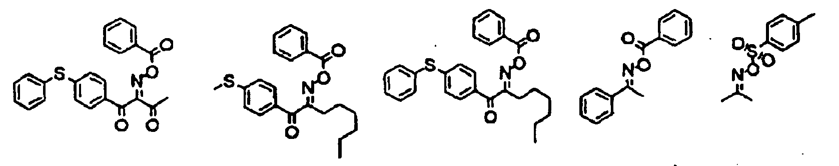

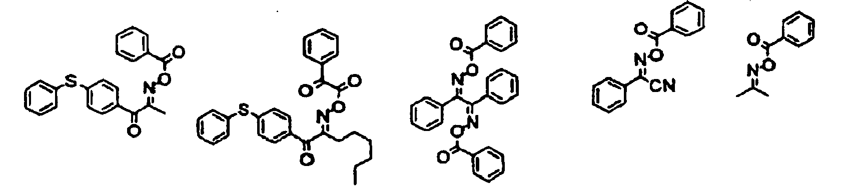

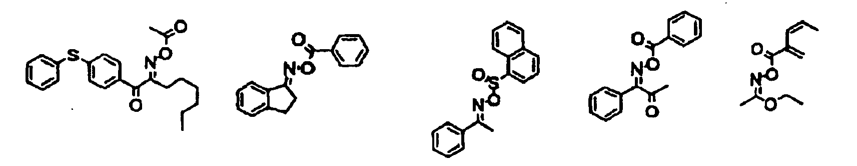

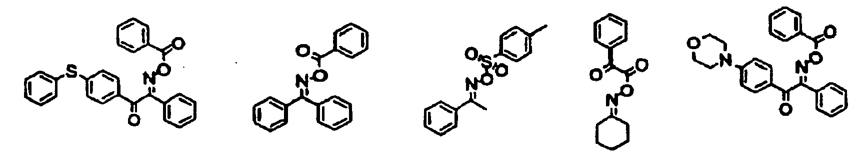

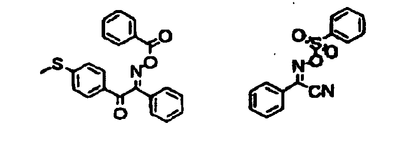

As the onium salt compounds, onium salts, e.g., the diazonium salts described in S.I. Schlesinger, Photogr. Sci. Eng., 18, 387 (1974), and T.S. Bal et al., Polymer, 21, 423 (1980), the ammonium salts disclosed in U.S. Patent 4,069,055 and JP-A-4-365049, the phosphonium salts disclosed in U.S. Patents 4,069,055 and 4,069,056, the iodonium salts disclosed in EP 104,143, U.S. Patents 339,049, 410,201, JP-A-2-150848 and JP-A-2-296514, the sulfonium salts disclosed in EP 370,693, EP 390,214, EP 233,567, EP 297,443, EP 297,442, U.S. Patents 4,933,377, 161,811, 410,201, 339,049, 4,760,013, 4,734,444, 2,833,827, German Patent Nos. 2,904,626, 3,604,580 and 3,604,581, the selenonium salts described in J.V Crivello et al., Macromolecules, 10 (6), 1307 (1977), and J.V Crivello et al., J. Polymer Sci., Polymer Chem. Ed., 17, 1047 (1979), and the arsonium salts described in C.S. Wen et al., Teh. Proc. Conf. Rad. Curing ASIA, p. 478, Tokyo, Oct (1988) are exemplified.

In the invention, these onium salts function as ionic radical polymerization initiators not as acid generators.

The onium salts preferably used in the invention are onium salts represented by any of the following formula (RI-I), (RI-II) or (RI-III).

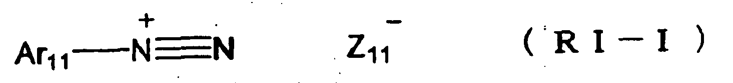

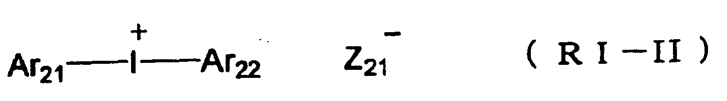

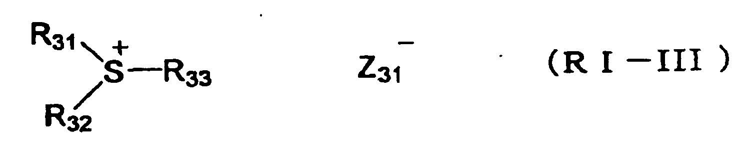

In formula (RI-I), Ar₁₁ represents an aryl group having 20 or less carbon atoms, which may have from 1 to 6 substituents, and as the preferred substituents, an alkyl group having from 1 to 12 carbon atoms, an alkenyl group having from 1 to 12 carbon atoms, an alkynyl group having from 1 to 12 carbon atoms, an aryl group having from 1 to 12 carbon atoms, an alkoxyl group having from 1 to 12 carbon atoms, an aryloxy group having from 1 to 12 carbon atoms, a halogen atom, an alkylamino group having from 1 to 12 carbon atoms, a dialkylamino group having from 1 to 12 carbon atoms, an alkylamido group or arylamido group having from 1 to 12 carbon atoms, a carbonyl group, a carboxyl group, a cyano group, a sulfonyl group, a thioalkyl group having from 1 to 12 carbon atoms, and a thioaryl group having from 1 to 12 carbon atoms are exemplified. Z₁₁⁻ represents a monovalent anion, specifically a halogen ion, a perchlorate ion, a hexafluorophosphate ion, a tetrafluoroborate ion, a sulfonate ion, a sulfinate ion, a thiosulfonate ion and a sulfate ion are exemplified. In view of stability, a perchlorate ion, a hexafluorophosphate ion, a tetrafluoro- borate ion, a sulfonate ion and a sulfinate ion are particularly preferred.

In formula (RI-II), Ar₂₁ and Ar₂₂ each represents an aryl group having 20 or less carbon atoms, which may have from 1 to 6 substituents, and as the preferred substituents, an alkyl group having from 1 to 12 carbon atoms, an alkenyl group having from 1 to 12 carbon atoms, an alkynyl group having from 1 to 12 carbon atoms, an aryl group having from 1 to 12 carbon atoms, an alkoxyl group having from 1 to 12 carbon atoms, an aryloxy group having from 1 to 12 carbon atoms, a halogen atom, an alkylamino group having from 1 to 12 carbon atoms, a dialkylamino group having from 1 to 12 carbon atoms, an alkylamido group or arylamido group having from 1 to 12 carbon atoms, a carbonyl group, a carboxyl group, a cyano group, a sulfonyl group, a thioalkyl group having from 1 to 12 carbon atoms, and a thioaryl group having from 1 to 12 carbon atoms are exemplified. Z₂₁⁻ represents a monovalent anion, specifically a halogen ion, a perchlorate ion, a hexafluoro- phosphate ion, a tetrafluoroborate ion, a sulfonate ion, a sulfinate ion, a thiosulfonate ion and a sulfate ion are exemplified. In view of stability and reactivity, a perchlorate ion, a hexafluorophosphate ion, a tetrafluoro- borate ion, a sulfonate ion, a sulfinate ion and a carboxylate ion are especially preferred.

In formula (RI-III), R₃₁, R₃₂ and R₃₃ each represents an aryl, alkyl, alkenyl or alkynyl group having 20 or less carbon atoms, which may have from 1 to 6 substituents. Above all, in view of stability and reactivity, an aryl group is preferred. As the substituents, an alkyl group having from 1 to 12 carbon atoms, an alkenyl group having from 1 to 12 carbon atoms, an alkynyl group having from 1 to 12 carbon atoms, an aryl group having from 1 to 12 carbon atoms, an alkoxyl group having from 1 to 12 carbon atoms, an aryloxy group having from 1 to 12 carbon atoms, a halogen atom, an alkylamino group having from 1 to 12 carbon atoms, a dialkylamino group having from 1 to 12 carbon atoms, an alkylamido group or arylamido group having from 1 to 12 carbon atoms, a carbonyl group, a carboxyl group, a cyano group, a sulfonyl group, a thioalkyl group having from 1 to 12 carbon atoms, and a thioaryl group having from 1 to 12 carbon atoms are exemplified. Z₃₁⁻ represents a monovalent anion, specifically a halogen ion, a perchlorate ion, a hexafluoro- phosphate ion, a tetrafluoroborate ion, a sulfonate ion, a sulfinate ion, a thiosulfonate ion, and a sulfate ion are exemplified. In view of stability and reactivity, a perchlorate ion, a hexafluorophosphate ion, a tetrafluoro- borate ion, a sulfonate ion, a sulfinate ion and a carboxylate ion are particularly preferred. The carboxylate ion disclosed in JP-A-2001-343742 is more preferred, and the carboxylate ion disclosed in JP-A-2002-148790 is especially preferred.

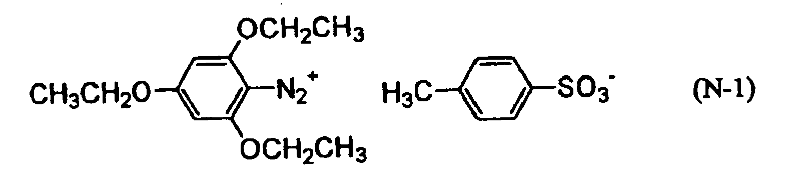

PF₆⁻ (N-2)

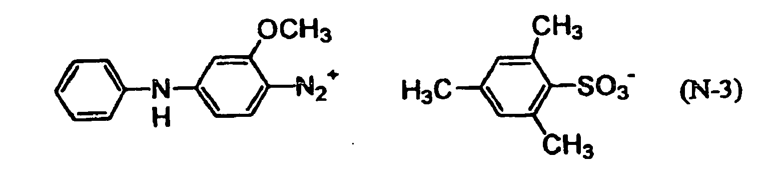

ClO₄⁻ (N-4)

PF₆⁻ (N-5)

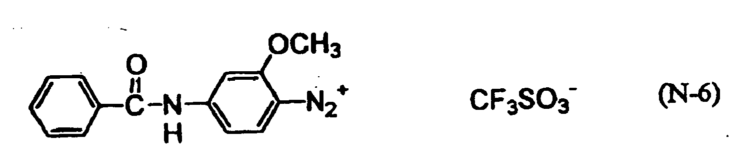

BF₄⁻ (N-7)

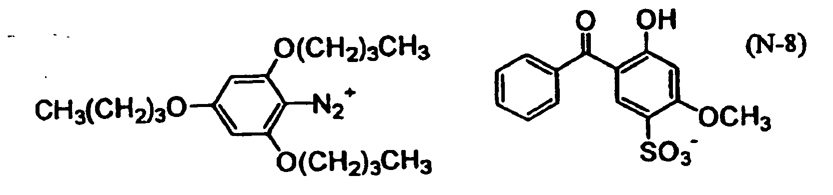

ClO₄⁻ (N-9)

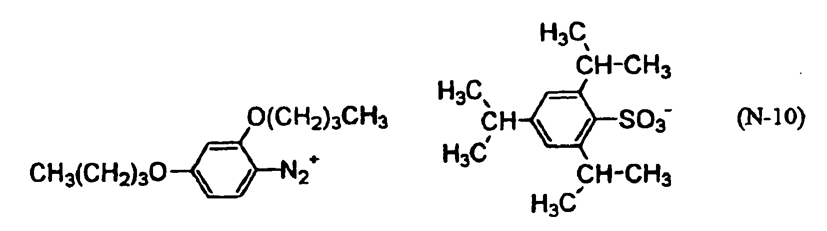

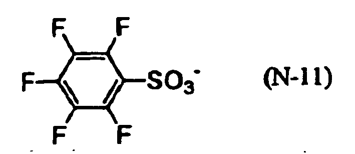

PF₈⁻ (N-12)

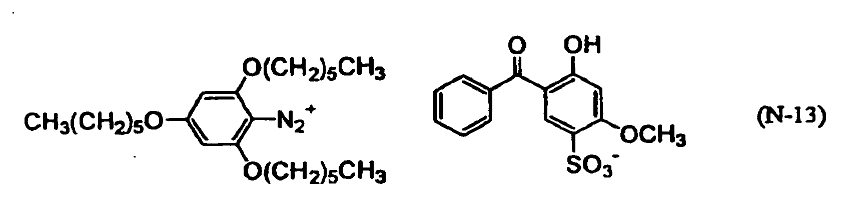

ClO₄⁻ (N-14)

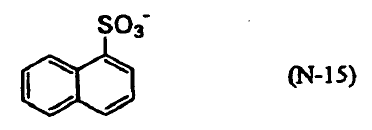

PF₆⁻ (N-16)

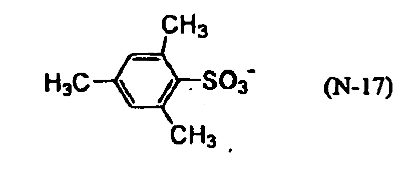

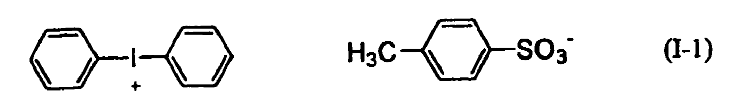

PF₆⁻ (I-2)

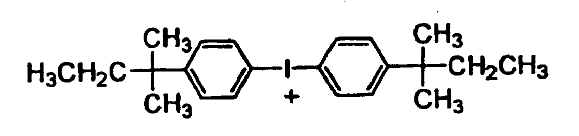

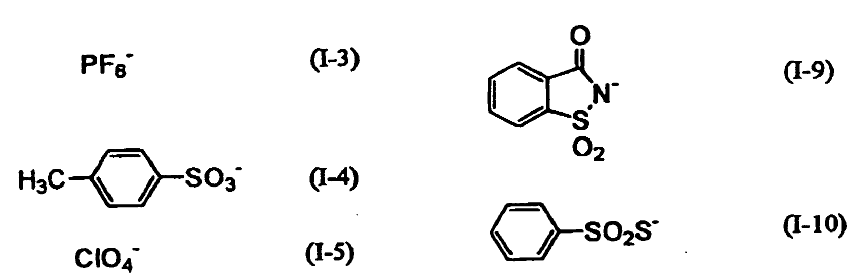

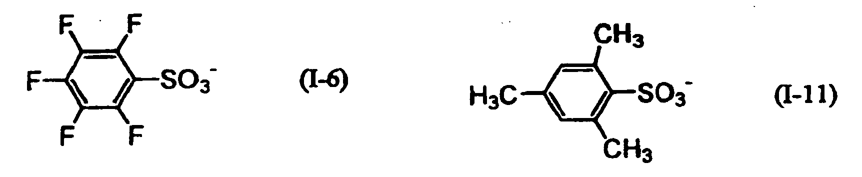

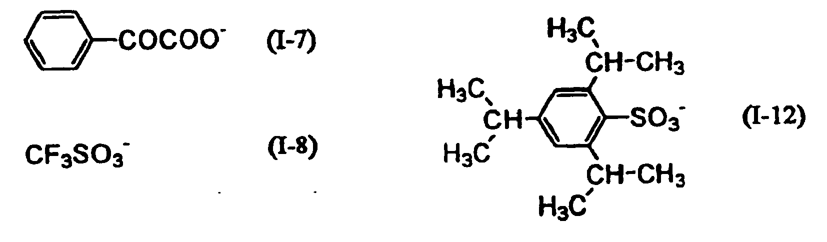

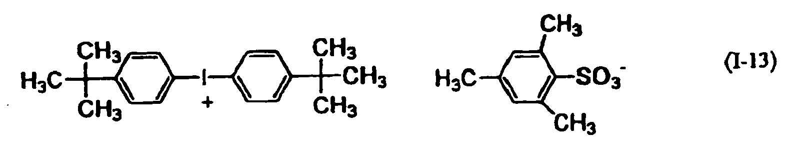

CIO₄⁻ (I-14)

PF₆⁻ (I-15)

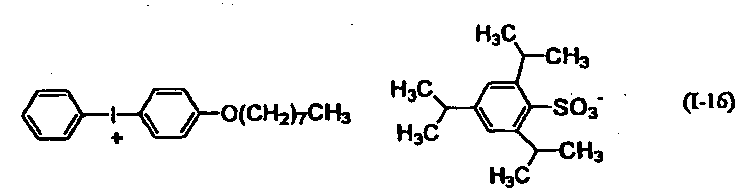

CF₃COO⁻ (I-17)

CF₃SO₃⁻ (I-18)

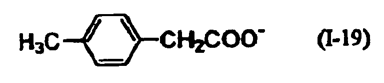

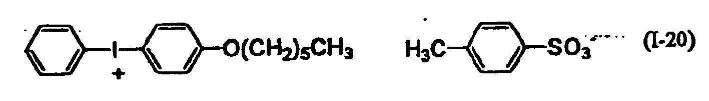

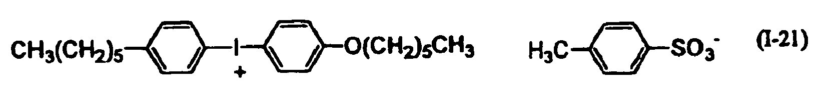

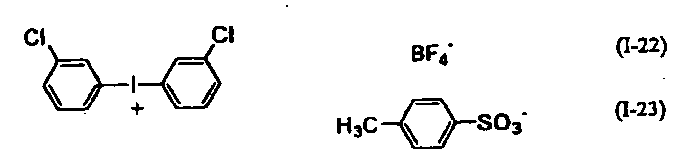

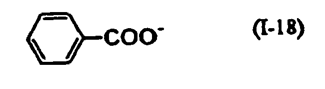

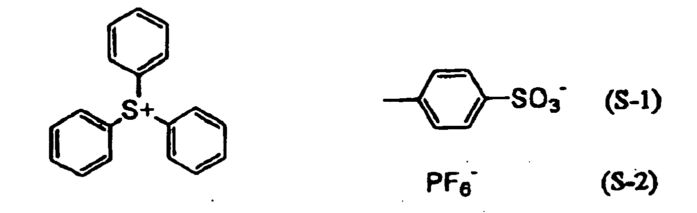

ClO₄⁻ (S-3)

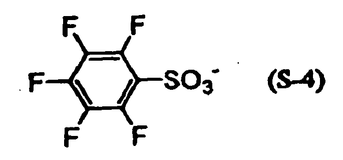

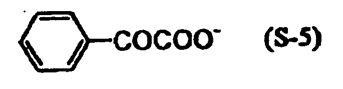

CF₃SO₃⁻ (S-6)

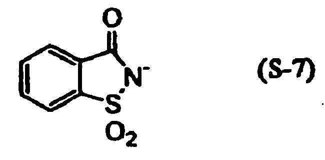

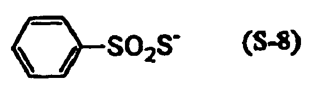

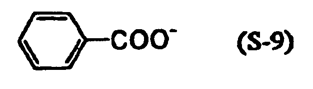

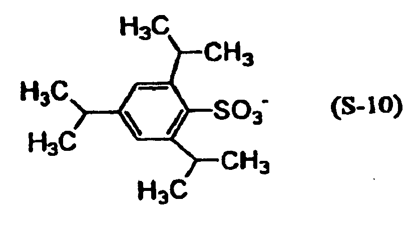

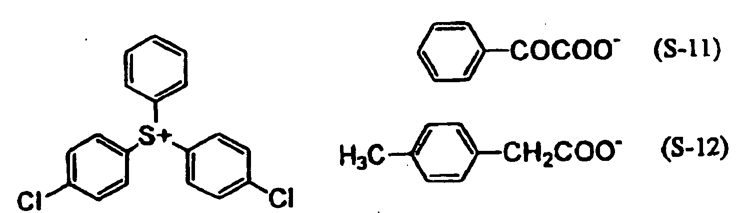

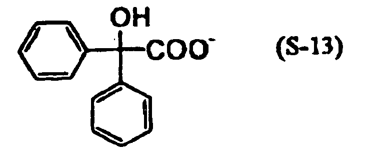

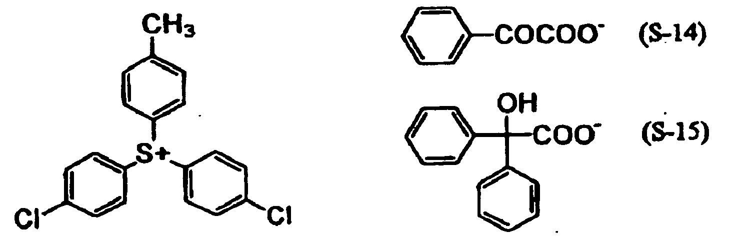

BF₄⁻ (S-16)

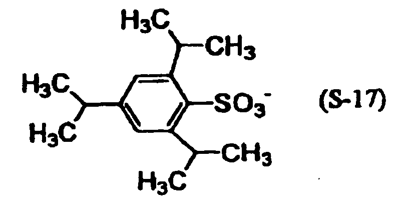

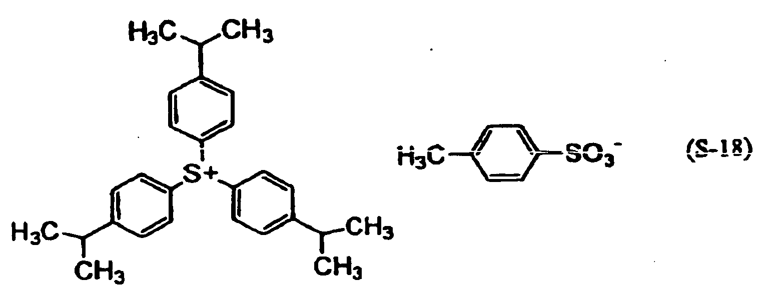

Polymerization initiators are not restricted to the above exemplified compounds, but in view of stability and reactivity, triazine initiators, organic halogen compounds, oxime ester compounds, diazonium salts, iodonium salts and sulfonium salts are more preferred.

### Sensitizer:

A sensitizer can be used in combination with the above polymerization initiator in an image-recording layer of a lithographic printing plate precursor that is imagewise exposed with a light source radiating rays of from 250 to 420 nm, whereby the rate of radical generation can be increased.

The specific examples of the sensitizers include benzoin, benzoin methyl ether, benzoin ethyl ether, 9-fluorenone, 2-chloro-9-fluorenone, 2-methyl-9-fluorenone, 9-anthrone, 2-bromo-9-anthrone, 2-ethyl-9-anthrone, 9,10-anthraquinone, 2-ethyl-9,10-anthraquinone, 2-t-butyl-9,10-anthraquinone, 2,6-dichloro-9,10-anthraquinone, xanthone, 2-methylxanthone, 2-methoxyxanthone, thioxanthone, benzyl, dibenzalacetone, p-(dimethylamino)phenyl styryl ketone, p-(dimethylamino)- phenyl p-methyl styryl ketone, benzophenone, p-(dimethyl- amino)benzophenone (or Michler's ketone), p-(diethylamino)-benzophenone, and benzanthrone.

Further, as a sensitizer preferably used in the invention, a compound represented by formula (II) disclosed in JP-B-51- 48516 is exemplified.

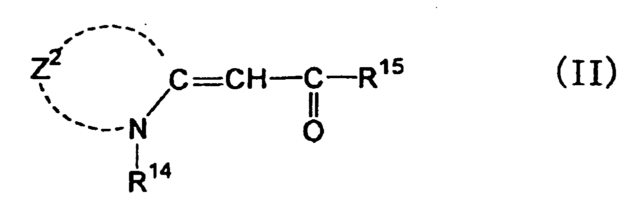

In formula (II), R¹⁴ represents an alkyl group (e.g., a methyl group, an ethyl group, a propyl group, etc.), or a substituted alkyl group (e.g., a 2-hydroxyethyl group, a 2-methoxyethyl group, a carboxymethyl group, a 2-carboxyethyl group, etc.); R¹⁵ represents an alkyl group (e.g., a methyl group, an ethyl group, etc.), or an aryl group (e.g., a phenyl group, a p-hydroxyphenyl group, a naphthyl group, a thienyl group, etc.).

Z² represents a non-metallic atomic group necessary to form a heterocyclic nucleus containing a nitrogen atom generally used in cyanine dyes, e.g., benzothiazoles (e.g., benzothiazole, 5-chlorobenzothiazole, 6-chlorobenzo- thiazole, etc.), naphthothiazoles (e.g., α-naphthothiazole, β-naphthothiazole, etc.), benzoselenazoles (e.g., benzo- selenazole, 5-chlorobenzoselenazole, 6-methoxybenzo- selenazole, etc.), naphthoselenazoles (e.g., α-naphtho- selenazole, β-naphthoselenazole, etc.), benzoxazoles (e.g., benzoxazole, 5-methylbenzoxazole, 5-phenylbenzoxazole, etc.), and naphthoxazoles (e.g., α-naphthoxazole, β-naphthoxazole, etc.).

The specific examples of the compounds represented by formula (II) have chemical structures in which Z², R¹⁴ and R¹⁵ are variously combined, and many compounds are present as well-known compounds. Accordingly, the compounds represented by formula (II) can be arbitrarily selected from well-known compounds. Further, as the preferred sensitizers for use in the invention, the merocyanine dyes disclosed in JP-B-5-47095 and the ketocoumarin-based compounds represented by the following formula (III) are also exemplified. 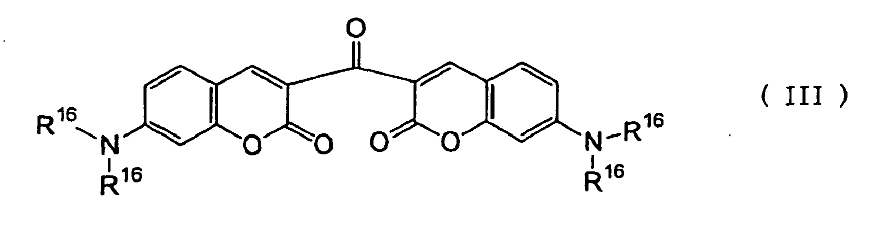 wherein R¹⁶ represents an alkyl group, e.g., a methyl group or an ethyl group.

The compounds disclosed in JP-A-2001-100412 and JP-A-2003-221517 as sensitizing dyes are also preferably used in the invention.

The addition amount of these sensitizers is preferably from 0.1 to 50 mass% to the total solids content constituting an image-recording layer, more preferably from 0.5 to 30 mass%, and particularly preferably from 0.8 to 20 mass%.

The addition amount of these polymerization initiators and sensitizers is preferably from 0.1 to 50 mass% to the total solids content constituting an image-recording layer, more preferably from 0.5 to 30 mass%, and particularly preferably from 0.8 to 20 mass%. When the addition amount is in this range, good sensitivity can be obtained and a non-image area is hardly soiled in printing.

Polymerization initiators may be used alone, or two or more initiators may be used in combination. Polymerization initiators may be added to the same layer with other components, or a separate layer may be provided and added thereto.

### (C) Polymerizable compound:

The polymerizable compounds usable in the invention are addition polymerizable compounds having at least one ethylenic unsaturated double bond, and they are selected from the compounds having at least one, preferably two or more, ethylenic unsaturated bond. These compounds are well known in the field of this industry, and they can be used with no particular limitation in the invention.

These polymerizable compounds have chemical forms of, e.g., a monomer, a prepolymer, i.e., a dimer, a trimer, an oligomer, and a mixture and a copolymer of them. As the examples of monomers and the copolymers of them, unsaturated carboxylic acids (e.g., acrylic acid, methacrylic acid, itaconic acid, crotonic acid, isocrotonic acid, maleic acid, etc.), and esters and amides of these unsaturated carboxylic acids are exemplified, and preferably esters of unsaturated carboxylic acids and aliphatic polyhydric alcohol compounds, and amides of unsaturated carboxylic acids and aliphatic polyhydric amine compounds are used. In addition, the addition reaction products of esters and amides of unsaturated carboxylic acids having a nucleophilic substituent such as a hydroxyl group, an amino group or a mercapto group with monofunctional or polyfunctional isocyanates or epoxies, and the dehydration condensation reaction products with monofunctional or polyfunctional carboxylic acids are also preferably used. Further, the addition reaction products of unsaturated carboxylic esters or amides having an electrophilic substituent such as an isocyanate group or an epoxy group with monofunctional or polyfunctional alcohols, amines or thiols, and the substitution reaction products of unsaturated carboxylic esters or amides having a separable substituent such as a halogen group or a tosyloxy group with monofunctional or polyfunctional alcohols, amines or thiols are also preferably used. As another example, it is also possible to use compounds in which the unsaturated carboxylic acids are replaced with unsaturated phosphonic acid, styrene, vinyl ether, etc.

The specific examples of monomers of the esters of aliphatic polyhydric alcohol compounds and unsaturated carboxylic acids include, as acrylic esters, ethylene glycol diacrylate, triethylene glycol diacrylate, 1,3-butanediol diacrylate, tetramethylene glycol diacrylate, propylene glycol diacrylate, neopentyl glycol diacrylate, trimethylolpropane triacrylate, trimethylolpropane tri(acryloyloxypropyl) ether, trimethylolethane triacrylate, hexanediol diacrylate, 1,4-cyclohexanediol diacrylate, tetraethylene glycol diacrylate, pentaerythritol diacrylate, penta- erythritol triacrylate, pentaerythritol tetraacrylate, dipentaerythritol diacrylate, dipentaerythritol hexaacrylate, sorbitol triacrylate, sorbitol tetraacrylate, sorbitol pentaacrylate, sorbitol hexaacrylate, tri(acryloyloxyethyl) isocyanurate, polyester acrylate oligomer, isocyanuric acid EO-modified triacrylate, etc.

As methacrylic esters, the examples include tetra- methylene glycol dimethacrylate, triethylene glycol dimethacrylate, neopentyl glycol dimethacrylate, trimethylolpropane trimethacrylate, trimethylolethane trimethacrylate, ethylene glycol dimethacrylate, 1,3-butanediol dimethacrylate, hexanediol dimethacrylate, pentaerythritol dimethacrylate, pentaerythritol trimethacrylate, pentaerythritol tetramethacrylate, dipentaerythritol dimethacrylate, dipentaerythritol hexamethacrylate, sorbitol trimethacrylate, sorbitol tetramethacrylate, bis[p-(3-methacryloxy-2-hydroxypropoxy)- phenyl]dimethylmethane, bis[p-(methacryloxyethoxy)phenyl]- dimethylmethane, etc.

As itaconic esters, the examples include ethylene glycol diitaconate, propylene glycol diitaconate, 1,3-butanediol diitaconate, 1,4-butanediol diitaconate, tetramethylene glycol diitaconate, pentaerythritol diitaconate, sorbitol tetraitaconate, etc. As crotonic esters, the examples include ethylene glycol dicrotonate, tetramethylene glycol dicrotonate, pentaerythritol dicrotonate, sorbitol tetradicrotonate, etc. As isocrotonic esters, the examples include ethylene glycol diisocrotonate, pentaerythritol diisocrotonate, sorbitol tetraisocrotonate, etc. As maleic esters, the examples include ethylene glycol dimaleate, triethylene glycol dimaleate, pentaerythritol dimaleate, sorbitol tetramaleate, etc.

As the examples of other esters, e.g., the aliphatic alcohol esters disclosed in JP-B-51-47334 and JP-A-57-196231, the esters having an aromatic skeleton disclosed in JP-A-59- 5240, JP-A-59-5241 and JP-A-2-226149, and the esters containing an amino group disclosed in JP-A-1-165613 are also preferably used in the present invention. The above ester monomers can also be used as mixtures.

Further, the specific examples of the amide monomers of aliphatic polyhydric amine compounds and unsaturated carboxylic acids include methylenebis-acrylamide, methylenebis-methacrylamide, 1,6-hexamethylenebis- acrylamide, 1,6-hexamethylenebis-methacrylamide, diethylenetriaminetris-acrylamide, xylylenebis-acrylamide, xylylenebis-methacrylamide, etc. As other preferred amide monomers, those having a cyclohexylene structure disclosed in JP-B-54-21726 can be exemplified.

Further, urethane-based addition polymerizable compounds manufactured by the addition reaction of isocyanate and a hydroxyl group are also preferably used. As the specific examples of such compounds, as disclosed in JP-B-48-41708, a vinyl urethane compound containing two or more polymerizable vinyl groups in one molecule obtained by adding vinyl monomer having a hydroxyl group represented by the following formula (A) to a polyisocyanate compound having two or more isocyanate groups in one molecule is exemplified.

CH₂=C(R₄)COOCH₂CH(R₅)OH (A)

wherein R₄ and R₅ each represents H or CH₃.

The urethane acrylates disclosed in JP-A-51-37193, JP-B-2-32293 and JP-B-2-16765, and the urethane compounds having an ethylene oxide skeleton disclosed in JP-B-58-49860, JP-B-56-17654, JP-B-62-39417 and JP-B-62-39418 are also preferably used in the invention. In addition, extremely high speed photopolymerizable compositions can be obtained by using addition polymerizable compounds having an amino structure and a sulfide structure in the molecule as disclosed in JP-A-63- 277653, JP-A-63-260909 and JP-A-1-105238.

As other examples, polyfunctional acrylates and methacrylates, such as polyester acrylates, and epoxy acrylates obtained by reacting epoxy resins with (meth)acrylic acids as disclosed in JP-A-48-64183, JP-B-49-43191 and JP-B-52-30490 can be exemplified. The specific unsaturated compounds disclosed in JP-B-46-43946, JP-B-1-40337 and JP-B-1-40336, and the vinyl sulfonic acid compounds disclosed in JP-A-2-25493 can also be exemplified. Further, according to cases, the structures containing a perfluoroalkyl group disclosed in JP-A-61-22048 are preferably used. Moreover, the photo-curable monomers and oligomers introduced into Bulletin of Nippon Setchaku Kyokai, Vol. 20, No. 7, pp. 300-308 (1984) can also be used.

The details in usage of these addition polymerizable compounds, e.g., what structure is to be used, whether the compound is to be used alone or in combination, or what an amount is to be used, can be optionally set up according to the final design of the performances of the lithographic printing plate precursor. For example, these things are selected on the basis of the following aspects.

In the point of sensitivity, the structure containing many unsaturated groups per a molecule is preferred and bifunctional or higher functional groups are preferred in many cases. For increasing the strength of an image area, i.e., a hardened film, trifunctional or higher functional groups are preferred, and it is also effective to use different functional numbers and different polymerizable groups (e.g., acrylic ester, methacrylic ester, styrene compounds, vinyl ether compounds) in combination to control both speed and strength.

Further, the selection and usage of the addition polymerizable compounds are important factors for the compatibility with other components in an image-recording layer (e.g., a binder polymer, a polymerization initiator, a colorant) and dispersibility, for example, in some cases compatibility can be improved by using low purity compounds or two or more compounds in combination. Further, it is also possible to select a compound having a specific structure for the purpose of improving the adhesion property to a support and a protective layer described later.

These polymerizable compounds are used preferably in an amount of from 5 to 80 mass% to all the solids content constituting an image-recording layer, and more preferably from 25 to 75 mass%. Polymerizable compounds may be used alone, or two or more compounds may be used in combination.

In addition, the structure, the blending method and the addition amount of these polymerizable compounds can be properly selected in view of the degree of polymerization hindrance by oxygen, resolution, a fogging property, refractive index change and surface stickiness and, further, in some cases, layer constitution and coating method of undercoating and upper coating may be taken.

### Microcapulse-microgel

In the present invention, a number of embodiments can be adopted as the method for incorporating the ingredients constituting the image-recording layer into the image-recording layer: one embodiment is, for example, a molecular dispersion-type image-recording layer obtained by dissolving the constituent ingredients in an appropriate solvent and coating it as set forth in JP-A-2002-287334. Another embodiment is a microcapsule-type image-recording layer which has all or part of the constituent ingredients encapsulated in microcapsules in the image-recording layer as set forth in JP-A-2001-277740 and JP-A-2001-277742. Furthermore, in a microcapsule-type image-recording layer, the constituent ingredients may be incorporated in the outside of the microcapsules. In such cases, a preferable embodiment is given by encapsulating hydrophobic constituent ingredients in microcapsules while hydrophilic constituent ingredients are contained in the outside of the microcapsules. Still further, as another embodiment, one in which corss-linked resin particles, i.e., microgel is contained in the image-recording layer is mentioned. The aforementioned microgel can contain part of the constituent ingredients therein and/or at the surface thereof In particular, an embodiment of making the microgel reactive by having a polymerizable compound contained at its surface is preferred from the viewpoints of image-forming sensitivity and printing durability.

To achieve a better on-press developability, the image-recording layer is preferably of the microcapsule-type or microgel-type.

As the method for encapsulation or micro-gelation of the ingredients constituting the image-recording layer, publicly known methods can be applied.

For example, as the manufacturing method for microcapsules, there are one making use of coacervation as set forth in US Patent Nos. 2800457 and 2800458, one based on interfacial polymerization as set forth in US Patent No. 3287154, and JP-A-38-19574 and JP-A-42-446, one based on polymer deposition as set forth in US Patent Nos. 3418250 and 3660304, one using an isocyanate polyol wall material as set forth in US Patent No: 3796669, one using an isocyanate wall material as set forth in US Patent No. 3914511, one using a urea/formaldehyde-based or urea/formaldehyde/resorsinol-based wall material as set forth in US Patent Nos. 4001140, 4087376 and 4089802, one using a melamine/formaldehyde resin, hydrocellulose or the like as the wall material as set forth in US Patent No. 4025445, the in situ method based on monomer polymerization as set forth in JP-A-36-9163 and JP-A-51-9079, the spray drying method as set forth in British Patent No. 930422 and US Patent No. 3111407, electrolytic dispersion cooling as set forth in Brit. Patent Nos. 952807 and 967074, etc. But the invention is not limited to these methods.

The microcapsule walls preferably used in the invention have three dimensional crosslinking and a property of swelling by a solvent. From this point of view, polyurea, polyurethane, polyester, polycarbonate, polyamide, and the mixtures of these compounds are preferably used as the microcapsule wall materials, and polyurea and polyurethane are particularly preferred. Compounds having crosslinkable functional groups such as ethylenic unsaturated bonds that can be used in binder polymers as described later may be introduced into microcapsule walls.

On the other hand, as the method of preparing microgel, the particle formation based on interfacial polymerization as set forth in JP-A-38-19574 and JP-A-42-446, and the particle formation based on non-aqueous dispersion polymerization as set forth in JP-A-5-61214 can be utilized. But, the invention is not limited to these methods.

As the method making use of the aforementioned interfacial polymerization, the above-described, publicly known method for microcapsule manufacture can be applied.

The microgel preferably used for the present invention is one prepared into a particulate form by interfacial polymerization and having a three-dimensional crosslinked structure. From such viewpoints, the materials to be used are preferably polyurea, polyurethane, polyester, polycarbonate and polyamide, and the mixture of these. Among these, polyurea and polyurethane are particularly preferred.

The average particle size of microcapsules or microgel is preferably from 0.01 to 3.0 µm, more preferably from 0.05 to 2.0 µm, and particularly preferably from 0.10 to 1.0 µm. Good resolution and aging stability can be obtained in this range of particle size.

### Other Image-Recording Layer Components:

The image-recording layer in the invention can further contain various additives according to necessity. These components are described below.

### Lipophilic Binder Polymer:

For increasing the film strength of the image-recording layer of the invention, the image-recording layer can use a lipophilic binder polymer (hereinafter abbreviated merely to "binder polymer"). The binder polymer is not particularly restricted and any well known compounds can be used, and polymers having a film-forming property are preferably used. The examples of such binder polymers include acrylic resins, polyvinyl acetal resins, polyurethane resins, polyurea resins, polyimide resins, polyamide resins, epoxy resins, methacrylic resins, polystyrene resins, novolak type phenolic resins, polyester resin, synthetic rubber and natural rubber.

Binder polymers may have a crosslinking property to improve the layer strength of an image area. For giving a crosslinkable property to binder polymers, it is effective to introduce a crosslinkable functional group such as an ethylenic unsaturated bond into the main chain or side chain of the binder polymers. A crosslinkable functional group may be introduced by copolymerization.

As the examples of polymers having an ethylenic unsaturated bond in the main chain of the molecule, poly-1,4-butadiene and poly-1,4-isoprene are exemplified.

As the examples of polymers having an ethylenic unsaturated bond in the side chain of the molecule, polymers of esters or amides of acrylic acid or methacrylic acid, wherein the residue of the ester or amide (R of -COOR or -CONHR) has an ethylenic unsaturated bond are exemplified.

The examples of the residues having an ethylenic unsaturated bond (the above-described R) include, -(CH₂)ₙCR¹=CR²R³, -(CH₂O)ₙCH₂CR¹=CR²R³, -(CH₂CH₂O)ₙCH₂CR¹=CR²R³, -(CH₂)ₙNH-CO-O-CH₂CR¹=CR²R³, -(CH₂)ₙ-O-CO-CR¹=CR²R³(CH₂CH₂O)₂-X (wherein R¹, R² and R³ each represents a hydrogen atom, a halogen atom, an alkyl group having from 1 to 20 carbon atoms, an aryl group, an alkoxyl group or an aryloxy group, and R¹ and R² or R³ may be bonded to each other to form a ring, n represents an integer of from 1 to 10, and X represents a dicyclopentadienyl residue).

The specific examples of the ester residues include -CH₂CH=CH₂ (disclosed in JP-B-7-21633), -CH₂CH₂O-CH₂CH=CH₂, -CH₂C(CH₃)=CH₂, -CH₂CH=CH-C₆H₅, -CH₂CH₂OCOCH=CH-C₆H₅, -CH₂CH₂-N-HCOO-CH₂CH=CH₂CH₂CH₂O-X (wherein X represents a dicyclopentadienyl residue).

The examples of the amido residues include -CH₂CH=CH₂, -CH₂CH₂-Y (wherein Y represents a cyclohexene residue), and -CH₂CH₂-OCO-CH=CH₂.

When free radicals (polymerization initiation radicals or the grown radicals of a polymerizable compound in the polymerization process) are added to the crosslinkable functional groups of a binder polymer having a crosslinking property, addition polymerization occurs directly between the polymers or via the polymerization chains of the polymerizable compound, as a result, crosslinking is formed between the molecules of the polymers and the binder polymer is hardened. Alternatively, the atoms in the polymer (e.g., the hydrogen atoms on the carbon atoms contiguous to crosslinkable functional groups) are extracted by free radicals and polymer radicals are grown, the polymer radicals are bonded to each other, whereby crosslinking is formed between the polymer molecules, so that the binder polymer is hardened.

The amount of crosslinkable groups contained in a binder polymer (the amount contained of radical polymerizable unsaturated double bonds by the iodometric titration method) is preferably from 0.1 to 10.0 mmol per gram of the binder polymer, more preferably from 1.0 to 7.0 mmol, and most preferably from 2.0 to 5.5 mmol. Good sensitivity and good storage stability can be obtained in this range of crosslinkable groups.

Binder polymers preferably have a weight average molecular weight of preferably 5,000 or higher, more preferably from 10,000 to 300,000, and a number average molecular weight of preferably 1,000 or higher, more preferably from 2,000 to 250,000. The polydisperse degree (weight average molecular weight/number average molecular weight) is preferably from 1.1 to 10.

Binder polymers can be synthesized by well known methods. As the solvents for use in the synthesis, e.g., tetrahydrofuran, ethylene dichloride, cyclohexanone, methyl ethyl ketone, acetone, methanol, ethanol, ethylene glycol monomethyl ether, ethylene glycol monoethyl ether, 2-methoxyethyl acetate, diethylene glycol dimethyl ether, 1-methoxy-2-propanol, 1-methoxy-2-propyl acetate, N,N-dimethylformamide, N,N-dimethylacetamide, toluene, ethyl acetate, methyl lactate, ethyl lactate, dimethyl sulfoxide, and water are exemplified. These solvents may be used alone or two or more solvents may be used as a mixture.

As the radical polymerization initiators used in the synthesis of binder polymers, well known compounds, e.g., azo initiators and peroxide initiators can be used.

Binder polymers are used in an amount of from 5 to 90 mass% to the total solids content of the image-forming layer, preferably from 5 to 80 mass%, and more preferably from 10 to 70 mass%. When binder polymers are used in this range, preferred strength of an image area and good image-forming property can be obtained.

It is preferred to use a polymerizable compound and a binder polymer in a mass ratio of from 0.5/1 to 4/1.

### Hydrophilic Resin:

In the invention, hydrophilic resins can be used in combination. Hydrophilic resins improve the permeability of a fountain solution into an image-recording layer to thereby improve on-press developability, and also effective for the dispersion stability of microcapsules.

As hydrophilic resins, hydrophilic resins having a hydrophilic group, e.g., a hydroxyl group, a carboxyl group, a carboxylate group, a hydroxyethyl group, a polyoxyethyl group, a hydroxypropyl group, a polyoxypropyl group, an amino group, an aminoethyl group, an aminopropyl group, an ammonium group, an amido group, a carboxymethyl group, a sulfonic acid group and a phosphoric acid group are preferably exemplified.

The specific examples of hydrophilic resins include gum arabic, casein, gelatin, starch derivatives, carboxymethyl cellulose and the sodium salt of it, cellulose acetate, sodium alginate, vinyl acetate-maleic acid copolymers, styrene- maleic acid copolymers, polyacrylic acids and the salts of them, polymethacrylic acids and the salts of them, homopolymers and copolymers of hydroxyethyl methacrylate, homopolymers and copolymers of hydroxyethyl acrylate, homopolymers and copolymers of hydroxypropyl methacrylate, homopolymers and copolymers of hydroxypropyl acrylate, homopolymers and copolymers of hydroxybutyl methacrylate, homopolymers and copolymers of hydroxybutyl acrylate, polyethylene glycols, hydroxypropylene polymers, polyvinyl alcohols, hydrolyzed polyvinyl acetate having a hydrolysis degree of 60 mol% or more, preferably 80 mol% or more, polyvinyl formal, polyvinyl butyral, polyvinyl pyrrolidone, homopolymers and copolymers of acrylamide, homopolymers and copolymers of methacrylamide, homopolymers and copolymers of N-methylolacrylamide, polyvinyl pyrrolidone, alcohol-soluble nylon, and polyether of 2,2-bis(4-hydroxyphenyl)propane and epichlorohydrin.

### Surfactant:

In the present invention, it is preferred to use a surfactant in an image-recording layer to accelerate the on-press development property at the time of initiating printing and to improve the conditions of coating surface. As the surfactants for these purposes, nonionic surfactants, anionic surfactants, cationic surfactants, ampholytic surfactants and fluorine surfactants are used. Surfactants may be used alone or two or more surfactants may be used in combination.

The nonionic surfactants for use in the invention are not particularly restricted and conventionally well known surfactants can be used, e.g., polyoxyethylene alkyl ethers, polyoxyethylene alkyl phenyl ethers, polyoxyethylene polystyryl phenyl ethers, polyoxyethylene polyoxypropylene alkyl ethers, glycerol fatty acid partial esters, sorbitan fatty acid partial esters, pentaerythritol fatty acid partial esters, propylene glycol monofatty acid esters, sucrose fatty acid partial esters, polyoxyethylene sorbitan fatty acid partial esters, polyoxyethylene sorbitol fatty acid partial esters, polyethylene glycol fatty acid esters, polyglycerol fatty acid partial esters, polyoxyethylenated castor oils, polyoxyethylene glycerol fatty acid partial esters, fatty acid diethanolamides, N,N-bis-2-hydroxyalkylamines, polyoxy- ethylene alkylamine, triethanolamine fatty acid esters, trialkylamine oxide, polyethylene glycol, and copolymers of polyethylene glycol and polypropylene glycol are exemplified.

The anionic surfactants for use in the invention are not particularly restricted and conventionally well known surfactants can be used, e.g., fatty acid salts, abietates, hydroxyalkanesulfonates, alkanesulfonates, dialkylsulfo- succinic esters, straight chain alkylbenzenesulfonates, branched chain alkylbenzenesulfonates, alkylnaphthalene-sulfonates, alkylphenoxy polyoxyethylene propyl sulfonates, polyoxyethylene alkyl sulfophenyl ethers, sodium N-methyl-N- oleyltaurine, disodium N-alkylsulfosuccinic acid monoamide, petroleum sulfonates, sulfated beef tallow, sulfuric esters of fatty acid alkyl ester, alkylsulfuric esters, polyoxy- ethylene alkyl ether sulfuric esters, fatty acid monoglyceride sulfuric esters, polyoxyethylene alkyl phenyl ether sulfuric esters, polyoxyethylene styryl phenyl ether sulfuric esters, alkylphosphoric esters, polyoxyethylene alkyl ether phosphoric esters, polyoxyethylene alkyl phenyl ether phosphoric esters, partial saponification products of styrene/maleic anhydride copolymers, partial saponification products of olefin/maleic anhydride copolymers, and naphthalene sulfonate formaldehyde condensation products are exemplified.

The cationic surfactants for use in the invention are not particularly restricted and conventionally well known surfactants can be used, e.g., alkylamine salts, quaternary ammonium salts, polyoxyethyene alkylamine salts, and polyethylene polyamine derivatives are exemplified.

The ampholytic surfactants for use in the invention are not particularly restricted and conventionally well known surfactants can be used, e.g., carboxybetaines, aminocarboxylic acids, sulfobetaines, aminosulfuric esters and imidazolines are exemplified.

In the above surfactants, "polyoxyethylene" can be taken as "polyoxyalkylene" such as polyoxymethylene, polyoxypropylene, and polyoxybutylene, and these surfactants can also be used in the invention.

As more preferred surfactants, fluorine surfactants containing a perfluoroalkyl group in the molecule are exemplified. As such surfactants, anionic surfactants, e.g., perfluoroalkylcarboxylate, perfluoroalkylsulfonate, and perfluoroalkylphosphate; ampholytic surfactants, e.g., perfluoroalkylbetaine; cationic surfactants, e.g., perfluoroalkyltrimethylammonium salt; and nonionic surfactants, e.g., perfluoroalkylamine oxide, perfluoroalkyl ethylene oxide addition products, oligomers containing a perfluoroalkyl group and a hydrophilic group, oligomers containing a perfluoroalkyl group and a lipophilic group, oligomers containing a perfluoroalkyl group, a hydrophilic group, and a lipophilic group, and urethane containing a perfluoroalkyl group and a lipophilic group are exemplified. Further, the fluorine surfactants disclosed in JP-A-62-170950, JP-A-62-226143 and JP-A-60-168144 are also preferably used.

Surfactants can be used alone, or two or more surfactants can be used in combination.

Surfactants are preferably used in an amount of from 0.001 to 10 mass% to all the solids content of the image recording layer, more preferably from 0.01 to 7 mass%.

### Printout Agent:

Compounds that discolor by acid or radical can be added to the image-recording layer of the invention for forming a printout images. As such compounds, various dyes, e.g., diphenylmethane, triphenylmethane, thiazine, oxazine, xanthene, anthraquinone, iminoquinone, azo and azomethine dyes are effectively used.

The specific examples of such dyes include Brilliant Green, Ethyl Violet, Methyl Green, Crystal Violet, Basic Fuchsine, Methyl Violet 2B, Quinaldine Red, Rose Bengal, Metanil Yellow, Thymolsulfophthalein, Xylenol Blue, Methyl Orange, Paramethyl Red, Congo Red, Benzopurpurine 4B, α-Naphthyl Red, Nile Blue 2B, Nile Blue A, Methyl Violet, Malachite Green, Parafuchsine, Victoria Pure Blue BOH (manufactured by HODOGAYA CHEMICAL Co., Ltd.), Oil Blue #603 (manufactured by Orient Chemical Industry Co., Ltd.), Oil Pink #312 (manufactured by Orient Chemical Industry Co., Ltd.), Oil Red 5B (manufactured by Orient Chemical Industry Co., Ltd.), Oil Scarlet #308 (manufactured by Orient Chemical Industry Co., Ltd.), Oil Red OG (manufactured by Orient Chemical Industry Co., Ltd.), Oil Red RR (manufactured by Orient Chemical Industry Co., Ltd.), Oil Green #502 (manufactured by Orient Chemical Industry Co., Ltd.), Spiron Red BEH Special (manufactured by HODOGAYA CHEMICAL Co., Ltd.), m-Cresol Purple, Cresol Red, Rhodamine B, Rhodamine 6G, Sulforhodamine B, Auramine, 4-p-diethylaminophenyliminonaphthoquinone, 2-carboxyanilino-4-p-diethylaminophenyliminonaphthoquinone, 2-carboxystearylamino-4-p-N,N-bis(hydroxyethyl)amino- phenyliminonaphthoquinone, 1-phenyl-3-methyl-4-p-diethyl- aminophenylimino-5-pyrazolone, and 1-β-naphthyl-4-p-diethylaminophenylimino-5-pyrazolone, and leuco dyes such as p,p',p"-hexamethyltriaminotriphenylmethane (Leuco Crystal Violet), Pergascript Blue SRB (manufactured by Ciga Geigy A.G).

In addition to the above, leuco dyes known as the materials of heat-sensitive paper and pressure-sensitive paper are also preferred. The specific examples of the leuco dyes include Crystal Violet Lactone, Malachite Green Lactone, Benzoyl Leuco Methylene Blue, 2-(N-phenyl-N-methylamino)-6- (N-p-tolyl-N-ethyl)aminofluoran, 2-anilino-3-methyl-6-(N-ethyl-p-toluidino)fluoran, 3,6-dimethoxyfluoran, 3-(N,N-diethylamino)-5-methyl-7-(N,N-dibenzylamino)fluoran, 3-(N-cyclohexyl-N-methylamino)-6-methyl-7-anilinofluoran, 3-(N,N-diethylamino)-6-methyl-7-anilinofluoran, 3-(N,N-diethylamino)-6-methyl-7-xylidinofluoran, 3-(N,N-diethyl-amino)-6-methyl-7-chlorofluoran, 3-(N,N-diethylamino)- 6-methoxy-7-aminofluoran, 3-(N,N-diethylamino)-7-(4- chloroanilino)fluoran, 3-(N,N-diethylamino)-7-chlorofluoran, 3-(N,N-diethylamino)-7-benzylaminofluoran, 3-(N,N-diethyl- amino)-7,8-benzofluoran, 3-(N,N-dibutylamino)-6-methyl-7- anilinofluoran, 3-(N,N-dibutylamino)-6-methyl-7-xylidinofluoran, 3-piperidino-6-methyl-7-anilinofluoran, 3-pyrrolidino-6-methyl-7-anilinofluoran, 3,3-bis(1-ethyl-2- methylindol-3-yl)phthalide, 3,3-bis(1-n-butyl-2-methyl- indol-3-yl)phthalide, 3,3-bis(p-dimethylaminophenyl)-6-dimethylaminophthalide, 3-(4-diethylamino-2-ethoxyphenyl)-3-(1-ethyl-2-methylindol-3-yl)-4-phthalide, and 3-(4-diethylaminophenyl)-3-(1-ethyl-2-methylindol-3 -yl)- phthalide.

The dyes that discolor by acid or radical are preferably added to an image-recording layer in an amount of from 0.01 to 15 mass%.

### Polymerization Inhibitor:

For preventing unnecessary thermal polymerization of polymerizable compounds during manufacture or preservation of an image-recording layer, it is preferred that a small amount of thermal polymerization inhibitors be added to the image- recording layer in the invention.

As the thermal polymerization inhibitors, e.g., hydroquinone, p-methoxyphenol, di-t-butyl-p-cresol, pyrogallol, t-butylcatechol, benzoquinone, 4,4'-thiobis(3-methyl-6-t-butylphenol), 2,2'-methylenebis(4-methyl-6-t-butylphenol), and N-nitroso-N-phenylhydroxylamine aluminum salt are exemplified.

The amount of the thermal polymerization inhibitors to be added is preferably from about 0.01 to about 5 mass% to all the solids content in the image-recording layer.

### Higher Fatty Acid Derivatives And the Like:

For preventing the polymerization hindrance due to oxygen, higher fatty acid derivatives, e.g., behenic acid and behenic acid amide, may be added to an image-recording layer in the invention and locally exist on the surface of the image-recording layer in the drying process after coating. The addition amount of the higher fatty acid derivatives is preferably from about 0.1 to about 10 mass% to the total solids content of the image-recording layer.

### Plasticizer:

The image-recording layer in the present invention may contain a plasticizer to improve on-press developability.

The examples of plasticizers include phthalates, e.g., dimethyl phthalate, diethyl phthalate, dibutyl phthalate, diisobutyl phthalate, dioctyl phthalate, octylcapryl phthalate, dicyclohexyl phthalate, ditridecyl phthalate, butylbenzyl phthalate, diisodecyl phthalate, and diallyl phthalate; glycol esters, e.g., dimethyl glycol phthalate, ethyl phthalyl ethyl glycolate, methyl phthalyl ethyl glycolate, butyl phthalyl butyl glycolate, and triethylene glycol dicaprylate; phosphates, e.g., tricresyl phosphate and triphenyl phosphate; aliphatic dibasic esters, e.g., diisobutyl adipate, dioctyl adipate, dimethyl sebacate, dibutyl sebacate, dioctyl azelate, and dibutyl maleate; and polyglycidyl methacrylate, triethyl citrate, glycerol triacetyl ester and butyl laurate.

The addition amount of plasticizers is preferably about 30 mass% or less to all the solids content in the image recording layer.

### Inorganic Fine Particles:

The image-recording layer of the invention may contain inorganic fine particles for the purposes of increasing the strength of the hardened film of an image area, and improving on-press developability.

As the inorganic fine particles, e.g., silica, alumina, magnesium oxide, titanium oxide, magnesium carbonate, calcium alginate and mixtures of these fine particles are preferably used. These inorganic fine particles can be used for the purpose of strengthening interface adhesion property by surface roughening treatment, even if they are not light-heat convertible.

The average particle size of inorganic fine particles is preferably from 5 nm to 10 µm, more preferably from 0.5 to 3 µm. With this range of the average particle size, inorganic fine particles are stably dispersed in the image-recording layer and the film strength of the image-recording layer can be sufficiently retained, thus a non-image area difficult to be soiled and excellent in hydrophilicity can be formed.

These inorganic fine particles are easily available as commercial products of colloidal silica dispersion and the like.

The addition amount of inorganic fine particles is preferably 20 mass% or less to all the solids content of the image-recording layer, more preferably 10 mass% or less.

### Low Molecular Weight Hydrophilic Compound:

For the improvement of on-press developability, the image-recording layer in the invention may contain hydrophilic low molecular weight compounds. As the hydrophilic low molecular weight compounds, water-soluble organic compounds, such as glycols, e.g., ethylene glycol, diethylene glycol, triethylene glycol, propylene glycol, dipropylene glycol, and tripropylene glycol, and ether or ester derivatives of these glycols, polyhydroxies, e.g., glycerol and pentaerythritol, organic amines, e.g., triethanolamine, diethanolamine and monoethanolamine, and salts thereof, organic sulfonic acids, e.g., toluenesulfonic acid and benzenesulfonic acid, and salts thereof, organic phosphonic acids, e.g., phenylphosphonic acid, and salts thereof, and organic carboxylic acids, e.g., tartaric acid, oxalic acid, citric acid, malic acid, lactic acid, gluconic acid and amino acid, and salts of these organic carboxylic acids are exemplified.

### Forming image-recording layer

An image-recording layer in the invention is formed by coating a coating solution prepared by dispersing or dissolving the above necessary constitutional components. As solvents used here, ethylene dichloride, cyclohexanone, methyl ethyl ketone, methanol, ethanol, propanol, ethylene glycol monomethyl ether, 1-methoxy-2-propanol, 2-methoxyethyl acetate, 1-methoxy-2-propyl acetate, dimethoxyethane, methyl lactate, ethyl lactate, N,N-dimethylacetamide, N,N-dimethyl- formamide, tetramethylurea, N-methylpyrrolidone, dimethyl sulfoxide, sulforan, γ-butyrolactone, toluene, and water are exemplified, but solvents are not limited thereto. These solvents are used alone or as mixture. The concentration of the solid contents of a coating solution is preferably from 1 to 50 mass%.

It is also possible to form an image-recording layer in the invention by preparing a plurality of coating solutions by dispersing or dissolving the same or different components in the same or different solvents, and repeating the coating and drying a plurality of times.

Although the coating amount of an image-forming layer (solids content) on a support obtained after coating and drying varies according to uses, it is generally preferably from 0.3 to 3.0 g/m². When the coating amount is in this range, good sensitivity and good film properties of an image-recording layer can be obtained.

Various coating methods can be used. For example, bar coating, rotary coating, spray coating, curtain coating, dip coating, air knife coating, blade coating, and roll coating can be used.

### Support:

Supports for use in the image-recording layer in the invention are not particularly limited and any materials can be used so long as they are dimensionally stable and plate-like materials. For example, paper, paper laminated with plastics (e.g., polyethylene, polypropylene, polystyrene, etc.), metal plates (e.g., aluminum, zinc, copper, etc.), plastic films (e.g., cellulose diacetate, cellulose triacetate, cellulose propionate, cellulose butyrate, cellulose acetate butyrate, cellulose nitrate, polyethylene terephthalate, polyethylene, polystyrene, polypropylene, polycarbonate, polyvinyl acetal, etc.), and paper and plastic films laminated or deposited with the above metals can be exemplified as the materials of the support. Preferred supports are a polyester film and an aluminum plate. Above all, aluminum sheets, which are dimensionally stable and comparatively inexpensive, are preferred.

Aluminum plates are a pure aluminum plate, alloy plates containing aluminum as a main component and a trace amount of different elements, and aluminum or aluminum alloy thin films laminated with plastics. The examples of different elements contained in aluminum alloys include silicon, iron, manganese, copper, magnesium, chromium, zinc, bismuth, nickel, titanium, etc. The different element content in aluminum alloys is preferably 10 mass% or less. In the invention, a pure aluminum plate is preferred but 100% pure aluminum is difficult to produce from the refining technique, accordingly, an extremely small amount of different elements may be contained. Thus, the compositions of aluminum plates used in the invention are not specified, and aluminum plates of conventionally well known and commonly used materials can be optionally used.

A support for use in the invention has a thickness of preferably from 0.1 to 0.6 mm, more preferably from 0.15 to 0.4 mm, and still more preferably from 0.2 to 0.3 mm.

Prior to the use of an aluminum plate, it is preferred for the aluminum plate to be subjected to surface treatment, e.g., surface roughening treatment and hydrophilic film forming treatment. By surface treatment, the improvement of hydrophilicity and the security of the adhesion of an image- recording layer and a support become easy. Prior to the surface roughening treatment of an aluminum plate, if necessary, degreasing treatment with a surfactant, an organic solvent or an alkaline aqueous solution is carried out to remove the rolling oil on the surface of an aluminum plate.

### Surface Roughening Treatment:

Surface roughening treatment of the surface of an aluminum plate is performed by various methods, e.g., mechanical surface roughening treatment, electrochemical surface roughening treatment (surface roughening treatment of electrochemically dissolving the surface), and chemical surface roughening treatment (surface roughening treatment of chemically selectively dissolving the surface) are exemplified.

As the method of mechanical surface roughening treatment, well-known methods, e.g., a ball rubbing method, a brush abrading method, a blast abrading method, or a buffing method, can be used.

As the method of electrochemical surface roughening treatment, a method of roughening in an electrolyte containing an acid such as a hydrochloric acid or a nitric acid by alternating current or direct current can be used. Further, a method of using mixed acids can be used as disclosed in JP-A-54-63902.

### Formation of Hydrophilic Layer:

The forming methods of a hydrophilic film are not especially restricted, and an anodizing method, a vacuum evaporation method, a CVD method, a sol/gel method, a sputtering method, an ion plating method, and a diffusing method can be arbitrarily used. Further, it is also possible to use a method of coating a solution obtained by mixing hollow particles in a hydrophilic resin or a sol/gel solution.

A process of producing an oxide by anodization, that is, using an anodizing process, is most preferred. Anodizing process can be carried out by the methods conventionally used in the industry. Specifically, by the application of DC or AC to an aluminum plate in an aqueous solution or nonaqueous solution comprising sulfuric acid, phosphoric acid, chromic acid, oxalic acid, sulfamic acid or benzenesulfonic acid alone or in combination of two or more, an anodic oxide film that is a hydrophilic film can be formed on the surface of the aluminum plate. The conditions of anodizing process change variously by the electrolytes used and cannot be determined unconditionally, but generally the concentration of an electrolyte of from 1 to 80 mass%, a liquid temperature of from 5 to 70°C, electric current density of from 0.5 to 60 A/dm², voltage of from 1 to 200 V, and electrolysis time of from 1 to 1,000 seconds are preferred. Of the anodizing processes, an anodizing process in a sulfuric acid electrolyte by high electric current density as disclosed in British Patent 1,412,768, and an anodizing process with a phosphoric acid as the electrolytic bath as disclosed in U.S. Patent 3,511,661 are preferred. It is also possible to perform a multi-stage anodizing process comprising anodization in a sulfuric acid electrolyte and further anodization in a phosphoric acid.

In the points of scratch resistance and press life, the anodic oxide film in the invention is preferably 0.1 g/m² or more, more preferably 0.3 g/m² or more, still more preferably 2 g/m² or more, and particularly preferably 3.2 g/m² or more. Considering that a great energy is required for forming a thick film, the anodic oxide film is preferably 100 g/m² or less, more preferably 40 g/m² or less, and particularly preferably 20 g/m² or less.

Minute concavities called micro pores evenly distributed are formed on the surface of an anodic oxide film. The density of micro pores on the surface of an anodic oxide film can be controlled by arbitrarily selecting the processing conditions. The thermal conductivity in the thickness direction of an anodic oxide film can be lowered by increasing the density of micro pores. In addition, the diameter of micro pores can be adjusted by arbitrarily selecting the processing conditions. The thermal conductivity in the thickness direction of an anodic oxide film can be lowered by making the diameter of micro pores larger.

It is preferred in the invention to perform a pore widening process of enlarging the pore diameter of micro pores after anodizing process for the purpose of lowering the thermal conductivity. The pore widening process is a process of dissolving an anodic oxide film to thereby enlarge the pore diameter of micro pores by immersing an aluminum substrate on which an anodic oxide film is formed in an acid aqueous solution or an alkali aqueous solution. The pore widening process is performed in the range of the dissolving amount of an anodic oxide film of preferably from 0.01 to 20 g/m², more preferably from 0.1 to 5 g/m², and particularly preferably from 0.2 to 4 g/m².

When an acid solution is used in a pore widening process, it is preferred to use an aqueous solution of inorganic acid such as sulfuric acid, phosphoric acid, nitric acid or hydrochloric acid, or an aqueous solution of the mixture of these acids. The concentration of an acid aqueous solution is preferably from 10 to 1,000 g/liter, more preferably from 20 to 500 g/liter. The temperature of an acid aqueous solution is preferably from 10 to 90°C, more preferably from 30 to 70°C. The time of immersion in an acid aqueous solution is preferably from 1 to 300 seconds, more preferably from 2 to 100 seconds. On the other hand, when an alkali aqueous solution is used in a pore widening process, it is preferred to use an aqueous solution containing at least one alkali selected from the group consisting of sodium hydroxide, potassium hydroxide and lithium hydroxide. The pH of an alkali aqueous solution is preferably from 10 to 13, more preferably from 11.5 to 13.0. The temperature of an alkali aqueous solution is preferably from 10 to 90°C, more preferably from 30 to 50°C. The time of immersion in an alkali aqueous solution is preferably from 1 to 500 seconds, more preferably from 2 to 100 seconds. However, too large an enlargement of the micro pore diameter on the outermost surface results in the deterioration of soiling resistance in printing, so that the micro pore diameter on the outermost surface is preferably 40 nm or less, more preferably 20 nm or less, and most preferably 10 nm or less. Accordingly, a more preferred anodic oxide film capable of compatibility of a heat insulating property and soiling resistance is an anodic oxide film having a surface micro pore diameter of from 0 to 40 nm and an inside micro pore diameter of from 20 to 300 nm. For example, it is known that when the kind of the electrolyte is the same, the pore diameter of the pore that occurs by the electrolysis is proportional to the electrolytic voltage at the time of electrolysis. By making use of the nature, a method of forming pores having a widened bottom part can be used by gradually increasing electrolytic voltage. It is also known that a pore diameter changes by changing the kind of electrolyte, and a pore diameter becomes larger in the order of a sulfuric acid, an oxalic acid, and a phosphoric acid. Accordingly, a method of anodization of using a sulfuric acid in the electrolyte of the first stage and a phosphoric acid in the second stage can be used. In addition, a support for a lithographic printing plate obtained by an anodizing process and a pore widening process may be subjected to a sealing process described later.

In addition to the above anodic oxide film, a hydrophilic film may be an inorganic film formed by a sputtering method, a CVD method, etc. As the compounds constituting an inorganic film, e.g., oxide, nitride, silicide, boride and carbide are exemplified. An inorganic film may be composed of a simple substance of a compound alone or may be composed of a mixture of compounds. As the compounds constituting an inorganic film, aluminum oxide, silicon oxide, titanium oxide, zirconium oxide, hafnium oxide, vanadium oxide, niobium oxide, tantalum oxide, molybdenum oxide, tungsten oxide, chromium oxide; aluminum nitride, silicon nitride, titanium nitride, zirconium nitride, hafnium nitride, vanadium nitride, niobium nitride, tantalum nitride, molybdenum nitride, tungsten nitride, chromium nitride, silicon nitride, boron nitride; titanium silicide, zirconium silicide, hafnium silicide, vanadium silicide, niobium silicide, tantalum silicide, molybdenum silicide, tungsten silicide, chromium silicide; titanium boride, zirconium boride, hafnium boride, vanadium boride, niobium boride, tantalum boride, molybdenum boride, tungsten boride, chromium boride; aluminum carbide, silicon carbide, titanium carbide, zirconium carbide, hafnium carbide, vanadium carbide, niobium carbide, tantalum carbide, molybdenum carbide, tungsten carbide, chromium carbide are specifically exemplified.

### Sealing Treatment:

As described above, in the invention, a support for a lithographic printing plate provided with a hydrophilic film may be subjected to a sealing process. As the sealing process used in the invention, sealing processes of an anodic oxide film by steam sealing under pressure and boiling water sealing as disclosed in JP-A-4-176690 and JP-A-11-301135 are exemplified. Well-known sealing processes can also be used in the invention, e.g., a silicate process, a bichromate aqueous solution process, a nitrite process, an ammonium acetate process, an electrodeposition sealing process, a triethanolamine process, a barium carbonate process, and a sealing process by boiling water containing a trace amount of phosphate, can be used. A forming system of a pore varies according to the manner of sealing process, for example, a pore is formed from the bottom when sealing is performed by an electrodeposition sealing process and a pore is formed from the top when steam sealing is performed. In addition, an immersing process in a solution, a spraying process, a coating process, a vacuum evaporation process, sputtering, ion plating, flame spray coating and metal plating are exemplified as sealing processes, but the process of sealing is not particularly limited in the invention. As a particularly preferred process, a sealing process using particles having an average particle size of from 8 to 800 nm as disclosed in JP-A-2002-214764 is exemplified.

The average particle size of the particles used in the sealing process using particles is from 8 to 800 nm, preferably from 10 to 500 nm, and more preferably from 10 to 150 nm. When sealing is performed with this range of particles, there is no possibility of the particles entering into the micro pores on a hydrophilic film and the effect of increasing sensitivity can be sufficiently obtained, further, the adhesion with an image-recording layer becomes sufficient and excellent press life can be ensured. The thickness of a particle layer is preferably from 8 to 800 nm, more preferably from 10 to 500 nm.

As the method of forming a particle layer, e.g., an immersing process in a solution, a spraying process, a coating process, an electrolytic process, a vacuum evaporation process, sputtering, ion plating, flame spray coating and metal plating are exemplified, but the method is not particularly restricted.

An electrolytic process is performed with DC or AC. As the waveforms of AC used in the electrolytic process, a sine wave, a rectangular wave, a triangular wave and a trapezoidal wave are exemplified. From the viewpoint of the manufacturing costs of an electric power unit, the frequencies of AC are preferably from 30 to 200 Hz, more preferably from 40 to 120 Hz. When a trapezoidal wave is used as the waveform of AC, the time required for the electric current to reach the peak from 0 (tp) is preferably from 0.1 to 2 msec, more preferably from 0.3 to 1.5 msec. When tp is less than 0.1 msec, great source voltage is required in the time of the rise of current waveform by the influence of impedance of power circuit, so that installation costs of electric source sometimes becomes high.

As hydrophilic particles, it is preferred to use Al₂O₃, TiO₂, SiO₂ and ZrO₂ respectively alone or in combination of two or more. An electrolyte can be obtained by suspending the above hydrophilic particles in water and the like so that the content of the particles becomes from 0.01 to 20 mass% of the total content. The pH of an electrolyte can be adjusted by adding, e.g., a sulfuric acid, to be charged positively or negatively. Electrolytic process is performed, e.g., by using DC with an aluminum plate as the cathode and with the above electrolyte on the conditions of the voltage of from 10 to 200 V for 1 to 600 seconds. According to this method, micro pores can be easily sealed while leaving voids in the micro pores on the anodic oxide film.

As sealing processes, the methods of providing any of the following layers by coating are exemplified, e.g., a layer comprising a compound having at least one amino group, and at least one group selected from the group consisting of a carboxyl group and a group of the salt thereof, a sulfo group and a group of the salt thereof as disclosed in JP-A-60-149491, a layer comprising a compound having at least one amino group and at least one hydroxyl group, and a compound selected from the salts thereof as disclosed in JP-A-60-232998, a layer containing a phosphate as disclosed in JP-A-62-19494, and a layer comprising a polymer compound having at least one monomer unit having a sulfo group as the repeating unit in the molecule as disclosed in JP-A-59-101651.

The methods of providing a layer of a compound selected from the following compounds are also exemplified, e.g., carboxymethyl cellulose; dextrin; gum arabic; phosphonic acids having an amino group such as 2-aminoethylphosphonic acid; organic phosphonic acids such as phenylphosphonic acid, naphthylphosphonic acid, alkylphosphonic acid, glycero- phosphonic acid, methylenediphosphonic acid, ethylene-diphosphonic acid, each of which may have a substituent; organic phosphoric esters such as phenylphosphoric ester, naphthylphosphoric ester, alkylphosphoric ester, glycero-phosphoric ester, each of which may have a substituent; organic phosphinic acids such as phenylphosphinic acid, naphthyl- phosphinic acid, alkylphosphinic acid, glycerophosphinic acid, each of which may have a substituent; amino acids such as glycine, β-alanine; and amine hydrochloride having a hydroxyl group such as triethanolamine hydrochloride.

Coating of a silane coupling agent having an unsaturated group can also be used in sealing process. The examples of silane coupling agents include N-3-(acryloxy-2-hydroxy- propyl)-3-aminopropyltriethoxysilane, (3-acryloxypropyl)-dimethylmethoxysilane, (3-acryloxypropyl)methyldimethoxy- silane, (3-acryloxypropyl)trimethoxysilane, 3-(N-allyl- amino)propyltrimethoxysilane, allyldimethoxysilane, allyltriethoxysilane, allyltrimethoxysilane, 3-butenyl- triethoxysilane, 2-(chloromethyl)allyltrimethoxysilane, methacrylamidopropyltriethoxysilane, N-(3-methacryloxy-2- hydroxypropyl)-3-aminopropyltriethoxysilane, (methacryloxymethyl)dimethyethoxysilane, methacryloxymethyltriethoxy- silane, methacryloxymethyltrimethoxysilane, methacryloxy- propyldimethylethoxysilane, methacryloxypropyldimethyl- methoxysilane, methacryloxypropylmethyldiethoxysilane, methacryloxypropylmethyldimethoxysilane, methacryloxy- propylmethyltriethoxysilane, methacryloxypropylmethyl- trimethoxysilane, methacryloxypropyltris(methoxyethoxy)-silane, methoxydimethylvinylsilane, 1-methoxy-3-(trimethyl- siloxy)butadiene, styrylethyltrimethoxysilane, 3-(N- styrylmethyl-2-aminoethylamino)propyltrimethoxysilane hydrochloride, vinyldimethylethoxysilane, vinyldiphenyl- ethoxysilane, vinylmethyldiethoxysilane, vinylmethyl- dimethoxysilane, O-(vinyloxyethyl)-N-(triethoxysilyl- propyl)urethane, vinyltriethoxysilane, vinyltrimethoxy- silane, vinyltri-t-butoxysilane, vinyltriisopropoxysilane, vinyltriphenoxysilane, vinyltris(2-methoxyethoxy)silane, diallylaminopropylmethoxysilane. Of these silane coupling agents, silane coupling agents having a methacryloyl group or an acryloyl group fast in the reactivity of an unsaturated group are preferred.

Besides the above, a sol/gel coating process as disclosed in JP-A-5-50779, a coating process of phosphonic acids as disclosed in JP-A-5-246171, a process of coating materials for back coating as disclosed in JP-A-6-234284, JP-A-6-191173 and JP-A-6-230563, a process of phosphonic acids as disclosed in JP-A-6-262872, a coating process as disclosed in JP-A-6-297875, an anodizing process as disclosed in JP-A-10-109480, and an immersion process method as disclosed in JP-A-2000-81704 and JP-A-2000-89466 are exemplified, and any method can be used.

After forming a hydrophilic film, if necessary, the surface of the aluminum plate is subjected to hydrophilizing process. As the hydrophilizing process, alkali metal silicate methods as disclosed in U.S. Patents 2,714,066, 3,181,461, 3,280,734 and 3,902,734 are known. These methods comprise immersion processing of a support in an aqueous solution of sodium silicate, or electrolytic processing. In addition, a method of processing an aluminum plate with potassium fluorozirconate as disclosed in JP-B-36-22063, and methods of processing with polyvinylphosphonic acid as disclosed in U.S. Patents 3,276,868, 4,153,461 and 4,689,272 are exemplified.

When a polyester film insufficient in a hydrophilic property of surface is used as a support in the invention, it is preferred to coat a hydrophilic layer to make the surface hydrophilic. As the hydrophilic layers, a hydrophilic layer provided by coating a coating solution containing the colloid of oxide or hydroxide of at least one element selected from beryllium, magnesium, aluminum, silicon, titanium, boron, germanium, tin, zirconium, iron, vanadium, antimony and transition metals as disclosed in JP-A-2001-199175, a hydrophilic layer having an organic hydrophilic matrix obtained by the crosslinking or pseudo-crosslinking of an organic hydrophilic polymer as disclosed in JP-A-2002-79772, a hydrophilic layer having an inorganic hydrophilic matrix obtained by sol/gel conversion comprising hydrolysis and condensation reaction of polyalkoxysilane, titanate, zirconate or aluminate, and a hydrophilic layer comprising an inorganic thin film having a surface containing a metallic oxide are preferred. Of these hydrophilic layers, a hydrophilic layer formed by coating a coating solution containing the colloid of oxide or hydroxide of silicon is preferred.

When a polyester film is used as a support in the invention, it is preferred to provide an antistatic layer on the hydrophilic layer side of the support, or on the opposite side to the hydrophilic layer, or on both sides. When an antistatic layer is provided between a support and a hydrophilic layer, the antistatic layer also contributes to the adhesion of the hydrophilic layer and the support. The polymer layers containing the dispersion of metallic oxide fine particles and a matting agent as disclosed in JP-A-2002-79772 can be used as the antistatic layers.

It is preferred that a support for use in the invention has a central line average surface roughness of from 0.10 to 1.2 µm. In this range of average surface roughness, good adhesion of the support and an image-recording layer, good press life and good soiling resistance can be obtained.

The color density of a support is preferably from 0.15 to 0.65 in terms of a reflection density value. A good image forming property due to antihalation in the time of image exposure and a good plate-detecting property after development can be obtained when the color density of a support is in this range.

### Back Coat Layer:

After surface treatment of a support or after forming an undercoat layer, if necessary, a backcoat can be provided on the back surface of the support.

As the backcoat, e.g., coating layers comprising organic polymer compounds as disclosed in JP-A-5-45885, and coating layers comprising metallic oxides obtained by hydrolysis and polycondensation of organic or inorganic metallic compounds as disclosed in JP-A-6-35174 are preferably used. Alkoxy compounds of silicon, e.g., Si(OCH₃)₄, Si(OC₂H₅)₄, Si(OC₃H₇)₄, Si(OC₄H₉)₄, are preferably used for the inexpensiveness and easy availability of the materials.

### Undercoat Layer:

In the lithographic printing plate precursor in the invention, in particular in the on-press development type lithographic printing plate precursor, if necessary, an undercoat layer can be provided between an image-recording layer and a support. The image-recording layer comes to be easily peeled off the support at an unexposed area by an undercoat layer, so that on-press developability is improved. In the case of infrared laser exposure, since an undercoat layer functions as a heat insulating layer, the heat generated by exposure does not diffuse to the support and is efficiently utilized, so that the improvement of sensitivity can be contrived.

As the undercoat layer, specifically the silane coupling agent having an addition polymerizable ethylenic double bond reactive group disclosed in JP-A-10-282679, and the phosphorus compounds having an ethylenic double bond reactive group disclosed in JP-A-2-304441 are preferred.

As particularly preferred undercoat layer, polymer resins obtained by copolymerizing a monomer having an adsorptive group/a monomer having a hydrophilic group/a monomer having a crosslinking group can be exemplified.

The essential component of polymer undercoating is an adsorptive group onto a hydrophilic support surface. The presence or absence of adsorptivity onto a hydrophilic support surface can be judged by the following method.

A coating solution obtained by dissolving a test compound in an easily dissolving solvent is prepared, and the coating solution is coated on a support in a dry weight of 30 mg/m² and dried. The support coated with the test compound is thoroughly washed with the easily dissolving solvent, and the amount of the residue of the test compound not removed by washing is measured, from which the amount of the compound adsorbed onto the support is computed. The residual amount may be determined by directly measurement, or may be computed from the determination of the test compound dissolved in the washing solution. The determination of the compound can be performed by fluorescent X-ray measurement, reflectance spectroscopic absorbance measurement, and liquid chromatography measurement. A compound having adsorptivity onto a support is a compound that remains by 1 mg/m² or more after washing as above.

Adsorptive groups onto a hydrophilic support surface are functional groups capable of causing chemical bonding (e.g., ionic bonding, hydrogen bonding, coordinate bonding, bonding by intermolecular force) with the substances present on a hydrophilic support surface (e.g., metal, metallic oxide) or functional groups (e.g., a hydroxyl group). The adsorptive groups are preferably an acid radical or a cationic group.

The acid radical has an acid dissociation constant (pKa) of preferably 7 or less. The examples of acid radicals include a phenolic hydroxyl group, a carboxyl group, -SO₃H, -OSO₃H, -PO₃H₂, -OPO₃H₂, -CONHSO₂-, -SO₂NHSO₂- and -COCH₂COCH₃, and -OPO₃H₂ and -PO₃H₂ are especially preferred. These acid radicals may be metal salts.

The cationic groups are preferably onium groups. The examples of onium groups include an ammonium group, a phosphonium group, an arsonium group, a stibonium group, an oxonium group, a sulfonium group, a selenonium group, a stannonium group, and an iodonium group. An ammonium group, a phosphonium group and a sulfonium group are preferred, and an ammonium group and a phosphonium group are more preferred, and an ammonium group is most preferred.

As especially preferred examples of monomers having an adsorptive group, the compounds represented by the following formula (IV) or (V) are exemplified.

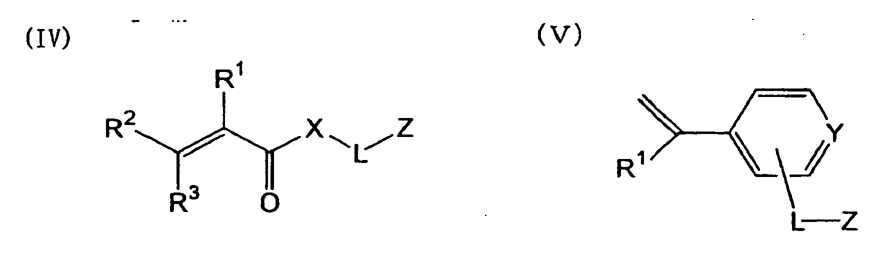

In formula (IV), R¹, R² and R³ each represents a hydrogen atom, a halogen atom, or an alkyl group having from 1 to 6 carbon atoms. R¹, R² and R³ each preferably represents a hydrogen atom or an alkyl group having from 1 to 6 carbon atoms, more preferably represents a hydrogen atom or an alkyl group having from 1 to 3 carbon atoms, and most preferably a hydrogen atom or a methyl group. R² and R³ each especially preferably represents a hydrogen atom.

In formula (IV), X represents an oxygen atom (-O-) or an imino group (-NH-), and X more preferably represents an oxygen atom. In formula (IV), L represents a divalent linking group. L preferably represents a divalent aliphatic group (an alkylene group, a substituted alkylene group, an alkenylene group, a substituted alkenylene group, an alkynylene group, a substituted alkynylene group), a divalent aromatic group (an arylene group, a substituted arylene group), or a divalent heterocyclic group, or combinations of these groups with an oxygen atom (-O-), a sulfur atom (-S-), imino (-NH-), substituted imino (-NR-, R represents an aliphatic group, an aromatic group or a heterocyclic group), or carbonyl (-CO-).

The aliphatic group may have a cyclic structure or a branched structure. The carbon atoms of the aliphatic group is preferably from 1 to 20, more preferably from 1 to 15, and most preferably from 1 to 10. As the aliphatic group, a saturated aliphatic group is preferred to an unsaturated aliphatic group. The aliphatic group may have a substituent, e.g., a halogen atom, a hydroxyl group, an aromatic group and a heterocyclic group are exemplified as the substituents.

The carbon atoms of the aromatic group is preferably from 6 to 20, more preferably from 6 to 15, and most preferably from 6 to 10. The aromatic group may have a substituent, e.g., a halogen atom, a hydroxyl group, an aliphatic group, an aromatic group and a heterocyclic group are exemplified as the substituents.

The heterocyclic group preferably has a 5- or 6-membered ring as a heterocyclic ring. Other heterocyclic ring, an aliphatic ring or an aromatic ring may be condensed with the heterocyclic ring. The heterocyclic ring may have a substituent, e.g., a halogen, atom, a hydroxyl group, an oxo group (=O), a thioxo group (=S), an imino group (=NH), a substituted imino group (=N-R, R represents an aliphatic group, an aromatic group or a heterocyclic group), an aliphatic group and an aromatic group are exemplified as the substituents.

L is preferably a divalent linking group containing a plurality of polyoxyalkylene structures. The polyoxyalkylene structures are more preferably polyoxyethylene structures. In other words, it is preferred for L to contain -(OCH₂CH₂)ₙ- (n is an integer of 2 or more).

In formula (IV), Z represents a functional group adsorptive to a hydrophilic support surface. Y represents a carbon atom or a nitrogen atom. In the case where Y is a nitrogen atom and L is linked on Y to form a quaternary pyridinum group, the group itself shows adsorptivity, so that Z is not essential.

In formula (V), R¹, L and Z have the same meaning as in formula (IV).

The examples of representative monomers represented by formula (IV) or (V) are shown below.

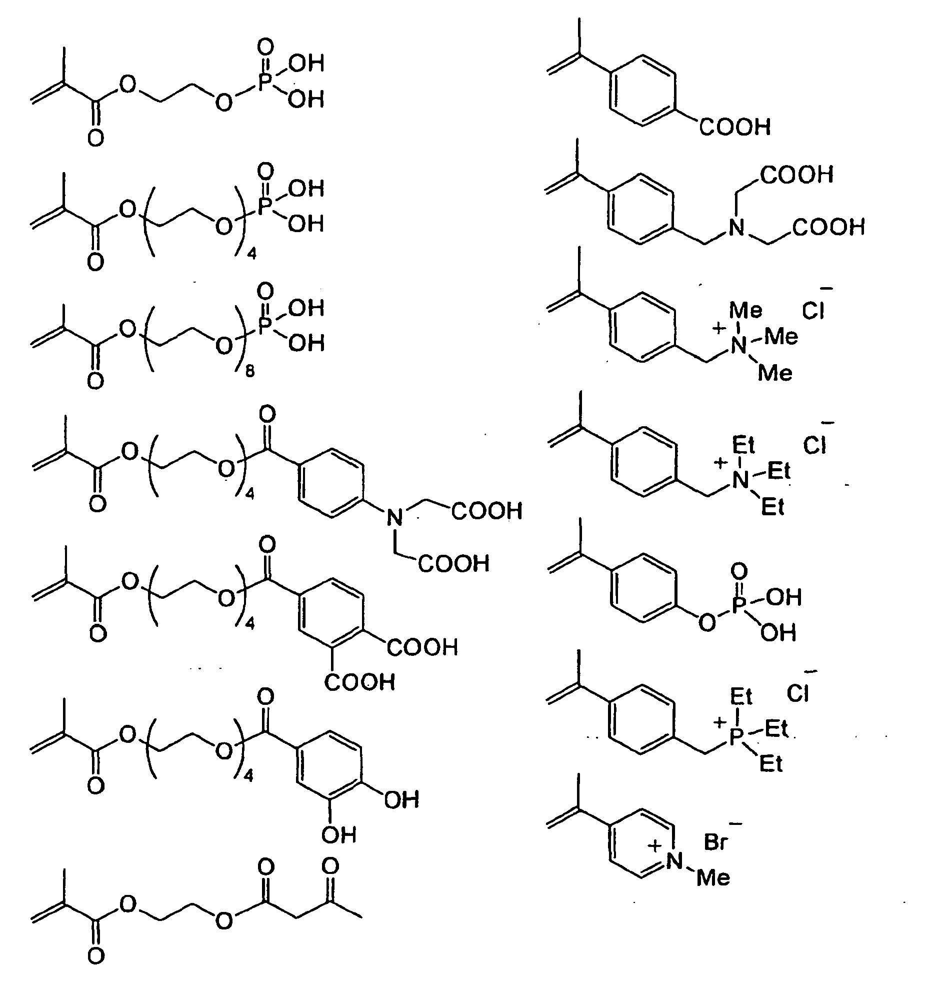

As the hydrophilic groups of polymer resins for undercoating usable in the invention, e.g., a hydroxyl group, a carboxyl group, a carboxylate group, a hydroxyethyl group, a polyoxyethyl group, a hydroxypropyl group, a polyoxypropyl group, an amino group, an aminoethyl group, an aminopropyl group, an ammonium group, an amido group, a carboxymethyl group, a sulfonic acid group, and a phosphoric acid group are preferably exemplified. Monomers having a sulfonic acid group showing a high hydrophilic property are especially preferred. As the specific examples of the monomers having a sulfonic acid group, sodium salts and amine salts of methallyloxybenzene- sulfonic acid, allyloxybenzenesulfonic acid, allylsulfonic acid, vinylsulfonic acid, allylsulfonic acid, p-styrene- sulfonic acid, methallylsulfonic acid, acrylamido-t-butyl- sulfonic acid, 2-acrylamido-2-methylpropanesulfonic acid, and (3-acryloyloxypropyl)butylsulfonic acid are exemplified. Methyl 2-acrylamido-2-methylpropanesulfonate is preferred for the hydrophilic performance and handling on synthesis.

It is preferred for the water-soluble polymer resins for the undercoat layer in the invention to have a crosslinking group. Adhesion of the undercoat layer to an image area can be heightened by a crosslinking group. For introducing a crosslinking group to a polymer resin for the undercoat layer, a method of introducing a crosslinking functional group, e.g., ethylenic unsaturated bond, to the side chain of the polymer, and a method of forming a salt structure by a substituent having counter charge of the polar substituent of the polymer resin and a compound having an ethylenic unsaturated bond can be used.

As the examples of polymers having an ethylenic unsaturated bond in the side chain of the molecule, polymers of acrylic or methacrylic esters or acrylic acid amides or methacrylic acid amides, wherein the residue of the ester or amide (R of -COOR or -CONHR) has an ethylenic unsaturated bond are exemplified.

The examples of the residues having an ethylenic unsaturated bond (the above-described R) include -(CH₂)ₙCR¹=CR²R³, -(CH₂O)ₙCH₂CR¹=CR²R³, -(CH₂CH₂O)ₙCH₂CR¹=CR²R³, -(CH₂)ₙNH-CO-O-CH₂CR¹=CR²R³, -(CH₂)ₙ-O-CO-CR¹=CR²R³ and (CH₂CH₂O)₂-X (wherein R¹, R² and R³ each represents a hydrogen atom, a halogen atom, an alkyl group having from 1 to 20 carbon atoms, an aryl group, an alkoxyl group or an aryloxy group, and R¹ and R² or R³ may be bonded to each other to form a ring, n represents an integer of from 1 to 10, and X represents a dicyclopentadienyl residue).

The specific examples of the ester residues include -CH₂CH=CH₂ (disclosed in JP-B-7-21633), -CH₂CH₂O-CH₂CH=CH₂, -CH₂C(CH₃)=CH₂, -CH₂CH=CH-C₆H₅, -CH₂CH₂OCOCH=CH-C₆H₅, -CH₂CH₂-NHCOO-CH₂CH=CH₂ and -CH₂CH₂O-X (wherein X represents a dicyclopentadienyl residue).

The examples of the amido residues include -CH₂CH=CH₂, -CH₂CH₂-Y (wherein Y represents a cyclohexene residue), and -CH₂CH₂-OCO-CH=CH₂.

As the monomers having a crosslinking group of the polymer resin for the undercoat layer, the above esters or amide of acrylic acid and methacrylic acid having a crosslinking group are preferred.

The amount of crosslinkable groups contained in polymer resin for the undercoat layer (the amount contained of radical polymerizable unsaturated double bonds by the iodometric titration method) is preferably from 0.1 to 10.0 mmol per gram of the polymer resin, more preferably from 1.0 to 7.0 mmol, and most preferably from 2.0 to 5.5 mmol. Good sensitivity, soiling resistance and good preservation stability can be obtained in this range of crosslinkable groups.

Polymer resins for the undercoat layer preferably have a weight average molecular weight of preferably 5,000 or higher, more preferably from 10,000 to 300,000, and a number average molecular weight of preferably 1,000 or higher, more preferably from 2,000 to 250,000. The polydisperse degree (weight average molecular weight/number average molecular weight) is preferably from 1.1 to 10.

Polymer resins for the undercoat layer may be any of a random polymer, a block polymer and a graft polymer, but a random polymer is preferred.

As the polymer resins for the undercoat layer, known resins having a hydrophilic group can also be used. The specific examples of such resins include gum arabic, casein, gelatin, starch derivatives, carboxymethyl cellulose and a sodium salt of carboxymethyl cellulose, cellulose acetate, sodium alginate, vinyl acetate-maleic acid copolymers, styrene-maleic acid copolymers, polyacrylic acids and the salts of them, polymethacrylic acids and the salts of them, homopolymers and copolymers of hydroxyethyl methacrylate, homopolymers and copolymers of hydroxyethyl acrylate, homopolymers and copolymers of hydroxypropyl methacrylate, homopolymers and copolymers of hydroxypropyl acrylate, homopolymers and copolymers of hydroxybutyl methacrylate, homopolymers and copolymers of hydroxybutyl acrylate, polyethylene glycols, hydroxypropylene polymers, polyvinyl alcohols, hydrolyzed polyvinyl acetate having a hydrolysis degree of 60 mass% or more, preferably 80 mass% or more, polyvinyl formal, polyvinyl butyral, polyvinyl pyrrolidone, homopolymers and copolymers of acrylamide, homopolymers and polymers of methacrylamide, homopolymers and copolymers of N-methylolacrylamide, polyvinyl pyrrolidone, alcohol-soluble nylon, and polyether of 2,2-bis(4-hydroxyphenyl)propane and epichlorohydrin.

Polymer resins for the undercoat layer may be used alone, or two or more may be used as mixture.

The coating amount of the undercoat layer (solids content) is preferably from 0.1 to 100 mg/m², more preferably from 1 to 30 mg/m².

### Protective Layer:

For preventing the generation of scratches on an image recording layer, for shielding oxygen, and for preventing ablation at the time of exposure with high intensity laser, if necessary, a protective layer may be provided on an image recording layer of the lithographic printing plate precursor of the invention.

Exposure is generally performed in the air in the invention, and the protective layer prevents the mixture into the image recording layer of low molecular weight compounds such as oxygen and basic substance in the air that hinder the image forming reaction occurring in the image-recording layer by exposure, by which the hindrance of the image-forming reaction by exposure in the air can be prevented. Accordingly, the characteristics required of the protective layer are to be low in permeability of low molecular weight compounds such as oxygen, good in transmission of light used for exposure, excellent in adhesion with an image-recording layer, and capable of being removed easily by on-press development after exposure. Protective layers having such characteristics have so far been variously examined and they are disclosed in detail, e.g., in U.S. Patent 3,458,311 and JP-B-55-49729.

As the materials that are used for the protective layer, for example, water-soluble polymer compounds relatively excellent in crystallizability are exemplified. Specifically, water-soluble polymers, e.g., polyvinyl alcohol, polyvinyl pyrrolidone, acid celluloses, gelatin, gum arabic, and polyacrylic acid are exemplified.

Above all, when polyvinyl alcohol (PVA) is used as the main component, the best results can be given to the fundamental characteristics such as an oxygen-shielding property and the removal by development. Polyvinyl alcohols may be partially substituted with ester, ether or acetal, or may partially contain other copolymer component so long as they contain an unsubstituted vinyl alcohol unit for imparting an oxygen- shielding property and solubility in water that are necessary to the protective layer.

As the specific examples of polyvinyl alcohols, those having a hydrolyzed rate of from 71 to 100 mol% and the degree of polymerization of from 300 to 2,400 are preferably exemplified. Specifically, PVA-105, PVA-110, PVA-117, PVA-117H, PVA-120, PVA-124, PVA-124H, PVA-CS, PVA-CST, PVA-HC, PVA-203, PVA-204, PVA-205, PVA-210, PVA-217, PVA-220, PVA-224, PVA-217EE, PVA-217E, PVA-220E, PVA-224E, PVA-405, PVA-420, PVA-613, and L-8 (manufactured by Kuraray Co., Ltd.) are exemplified.

The components of the protective layer (the selection of PVA, the use of additives, etc.), and the coating amounts are suitably selected by considering fogging characteristic, adhesion and scratch resistance besides the oxygen shielding property and the removal by development. In general, the higher the hydrolyzing rate of PVA (that is, the higher the unsubstituted vinyl alcohol unit content in the protective layer), and the higher the layer thickness, the higher is the oxygen-shielding property, thus advantageous in the point of sensitivity. For the prevention of the generation of unnecessary polymerization reaction during manufacture and storage, or the generation of unnecessary fog and thickening of image lines in image exposure, it is preferred that an oxygen-permeating property is not too high. Therefore, oxygen permeability A at 25°C under 1 atm is preferably, 0.2 ≦ A ≦ 20 (ml/m²· day).

As other components of the protective layer, glycerol, dipropylene glycol and the like can be added in an amount of several mass% to the water-soluble polymer compounds to provid flexibility, and further, anionic surfactants, e.g., sodium alkylsulfate and sodium alkylsulfonate; ampholytic surfactants, e.g., alkylaminocarboxylate and alkylaminodicarboxylate; and nonionic surfactants, e.g., polyoxyethylene alkyl phenyl ether, can be added to the (co)polymers each in an amount of several mass%.

The layer thickness of the protective layer is preferably from 0.1 to 5 µm, and particularly preferably from 0.2 to 2 µm.

The adhesion of the protective layer with an image part and scratch resistance are also very important in treating a lithographic printing plate precursor. That is, when a protective layer that is hydrophilic by containing a water-soluble polymer compound is laminated on a lipophilic image-recording layer, layer peeling of the protective layer due to insufficient adhesion is liable to occur, and sometimes a defect such as film hardening failure attributing to polymerization hindrance by oxygen is caused at the peeled part.

Various countermeasures have been proposed for improving the adhesion of an image-recording layer and a protective layer. For example, it is disclosed in JP-A-49-70702 and British Patent Application No. 1,303,578 that sufficient adhesion can be obtained by mixing from 20 to 60 mass% of an acryl-based emulsion or a water-insoluble vinyl pyrrolidone/vinyl acetate copolymer with a hydrophilic polymer mainly comprising polyvinyl alcohol and laminating the resulting product on an image-recording layer. Any of these well-known techniques can be used in the present invention. The coating methods of a protective layer are disclosed in detail, e.g., in U.S. Patent 3,458,311 and JP-B-55-49729.

Further, other functions can be imparted to a protective layer. For example, by the addition of colorants excellent in transmission of infrared rays that are used in exposure and capable of efficiently absorbing lights of other wavelengths (e.g., water-soluble dyes), safelight aptitude can be improved without causing sensitivity reduction.

### EXAMPLE

The invention will be described with reference to examples and but the invention is not limited thereto.

### 1. Manufacture of Lithographic Printing Plate Precursor

### 1-1. Manufacture of Lithographic Printing Plate Precursor (1)

### (1) Manufacture of support

For removing the rolling oil of the surface, an aluminum plate having a thickness of 0.3 mm (material 1050) was subjected to degreasing treatment with a 10 mass% sodium alminate aqueous solution at 50°C for 30 seconds, and then the aluminum surface was subjected to brush-graining with three nylon brushes planted with hairs having a hair diameter of 0.3 mm and a suspension of pumice stone and water of a median diameter of 25 µm (the specific gravity: 1.1 g/cm3), and the surface of the plate was thoroughly washed with water. The plate was immersed in a 25 mass% sodium hydroxide aqueous solution at 45°C for 9 seconds for etching, and washed with water. After water washing, the plate was further immersed in a 20 mass% nitric acid aqueous solution at 60 °C for 20 seconds followed by washing with water. The etched amount of the surface by graining was about 3 g/m².

Electrochemical surface roughening treatment was performed continuously by alternating voltage of 60 Hz. The electrolyte at this time was an aqueous solution containing 1 mass% of a nitric acid (containing a 0.5 mass% of an aluminum ion) and the liquid temperature was 50°C. As the alternating current electric source waveform, trapezoidal rectangular waveform alternating current was used, the time TP required for the electric current value to reach the peak from 0 was 0.8 msec, the duty ratio was 1/1, and electrochemical surface roughening treatment was performed with a carbon electrode as the counter electrode. Ferrite was used as the auxiliary anode. The electric current density was 30 A/dm² at a peak value of electric current, and 5% of the electric current from the electric source was diverted to the auxiliary anode. The quantity of electricity was 175 C/dm² in the quantity of electricity in the case where the aluminum plate was the anode. The aluminum plate was then washed with water.

Subsequently, electrochemical surface roughening treatment of the aluminum plate was performed with an electrolyte containing a 0.5 mass% hydrochloric acid aqueous solution (containing 0.5 mass% of aluminum ion) at a liquid temperature of 50°C on the condition of the quantity of electricity of 50 C/dm² in the case where the aluminum plate was the anode in the same manner as in the above nitric acid electrolysis. The plate was then subjected to spray washing. The plate was provided with 2.5 g/m² of an anodic oxide film with an electrolyte containing a 15 mass% sulfuric acid (containing 0.5 mass% of aluminum ion) with the electric current density of 15 A/dm², and then washed and dried.

After that, the plate was immersed in a solution containing 0.1 mass% of sodium fluorozirconate and 1 mass% of sodium dihydrogenphosphate having a pH value of 3.7 at 75°C for 10 seconds to perform sealing treatment. Then the plate was subjected to treatment with a 2.5 mass% sodium silicate aqueous solution at 30°C for 10 seconds. The central line average surface roughness (Ra) of the plate measured with a needle having a diameter of 2 µm was 0.51 µm.

The following undercoat layer coating solution (1) was coated on the plate in a dry coating weight of 10 mg/m² to prepare a support for use in the following test.

| Undercoat layer coating solution (1): | |
|---|---|
| Compound (1) shown below for undercoating | 0.017 g |
| Methanol | 9.00 g |
| Water | 1.00 g |

### Compound (1) for Undercoating

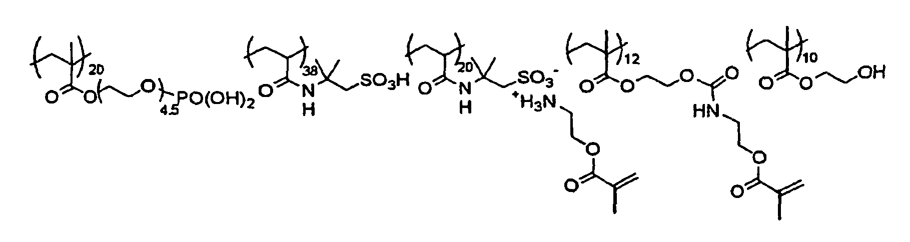

### (2) Formation of image-recording layer

The image-recording layer coating solution (1) having the composition shown below was coated on the above support with bar coating, dried at 100°C for 60 seconds in an oven, whereby an image-recording layer having a dry coating amount of 1.0 g/m² was formed, whereby a lithographic printing plate precursor was obtained.

The image-recording layer coating solution (1) was obtained by blending and stirring just before coating the following photosensitive solution (1) and microcapsule solution (1).

### Photosensitive solution (1):

| | |
|---|---|
| Binder polymer (1) | 0.162 g |
| Polymerization initiator shown below | 0.100 g |
| Infrared absorber (1) shown below | 0.020 g |
| Polymerizable compound | 0.385 g |
| Aronix M215, manufactured by TOAGOSEI CO., LTD. | |
| Fluorine surfactant (1) shown below | 0.044 g |
| (Megafac F-176, manufactured by Dainippon Ink and Chemicals Inc. | |
| Methyl ethyl ketone | 1.091 g |
| 1-Methoxy-2-propanol | 8.609 g |

### Microcapsule solution (1):

| | |
|---|---|
| Microcapsule synthesized as follows | 2.640 g |
| Water | 2.425 g |

### Binder Polymer (1)

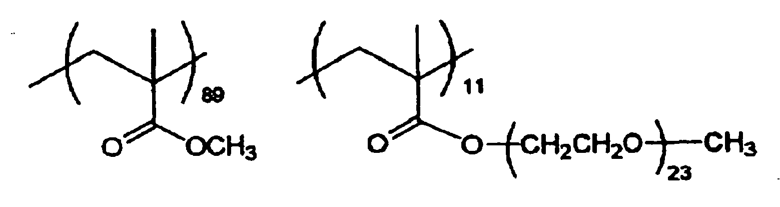

### Polymerization Initiator (1)

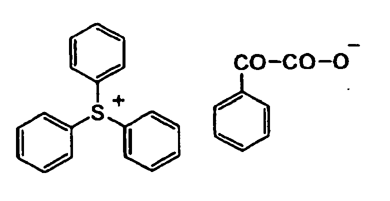

### Infrared Absorber (1)

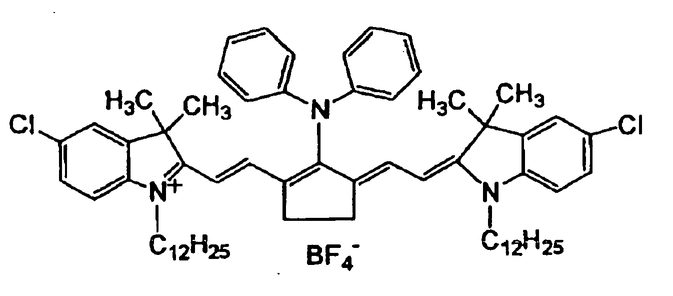

### Fluorine Surfactant (1)

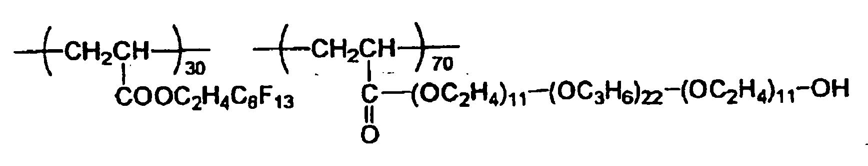

### Synthesis of microcapsule (1):

As the oil phase component, 10 g of the addition product of trimethylolpropane and xylene diisocyanate (Takenate D-110N, manufactured by Mitsui Takeda Chemicals Inc.), 3.15 g of pentaerythritol triacrylate (SR444, manufactured by Nippon Kayaku Co., Ltd.), 0.35 g of the following infrared absorber (1), 1 g of 3-(N,N-diethylamino)-6-methyl-7-anilinofluoran (ODB, manufactured by YAMAMOTO CHEMICALS INC.), and 0.1 g of Pionin A-41C (manufactured by Takemoto Oil & Fat) were dissolved in 17 g of ethyl acetate. As the aqueous phase component, 40 g of a 4 mass% aqueous solution of PVA-205 was prepared. The oil phase component and the aqueous phase component were mixed, and emulsified with a homogenizer at 12,000 rpm for 10 minutes. The obtained emulsified product was added to 25 g of distilled water, stirred at room temperature for 30 minutes, and then stirred at 40°C for 3 hours. The concentration of the solids content of the obtained microcapsule solution (1) was diluted to reach 15 mass% with distilled water. The average particle size was 0.2 µm.

### (3) Formation of protective layer

Protective layer coating solution (1) having the following composition was coated on the image-recording layer with bar coating, dried at 125°C for 75 seconds in an oven, whereby a protective layer having a dry coating weight of 0.1 mg/m² was formed, whereby a lithographic printing plate precursor (1) for use in Examples 1 to 13 and Comparative Examples 20 to 23 was obtained.

| Protective layer coating solution (1): | |
|---|---|
| Polyvinyl alcohol (Poval PVA105) (manufactured by Kuraray Co., Ltd., saponification degree: 98 to 99 mol%, polymerization degree: 500) | 0.895 g |
| Polyvinyl pyrrolidone (K30) (manufactured by Wako Pure Chemical Industries, weight average molecular weight: 400,000) | 0.035 g |
| Polyvinyl pyrrolidone copolymer (Luviscole VA 64 W, manufactured by BASF Japan, weight average molecular weight: 34,000, vinyl pyrrolidone/vinyl acetate copolymer (molar ratio: 60/40) (50 mass% aqueous solution) | 0.048 g |
| Nonionic surfactant | 0.020 g |
| EMALEX710 (trade name), manufactured by Nihon Emulsion Co. | |
| Water | 15.200 g |

### 1-2. Manufacture of Lithographic Printing Plate Precursor (2)

Lithographic printing plate precursor (2) for use in Examples 14 to 16 and Comparative Example 3 was prepared in the same manner as in the preparation of lithographic printing plate precursor (1) except that image-recording layer coating solution (2) having the composition shown below was used in place of image-recording layer coating solution (1).

| Image-recording layer coating solution (2): | |
|---|---|
| Infrared absorber (2) shown below | 0.05 g |
| Polymerization initiator (1) shown above | 0.20 g |
| Binder polymer (2) shown below (average molecular weight: 80,000) | 0.50 g |
| Polymerizable compound Aronix.M215, manufactured by TOAGOSEI CO., LTD. | 1.00 g |
| Naphthalene sulfonate of Victoria Pure Blue | 0.02 g |
| Fluorine surfactant (1) shown above | 0.10 g |
| Methyl ethyl ketone | 18.0 g |

### Infrared Absorber (2)

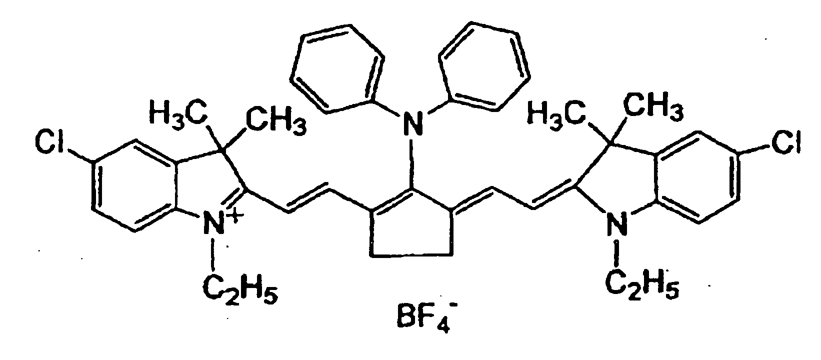

### Binder Polymer (2)

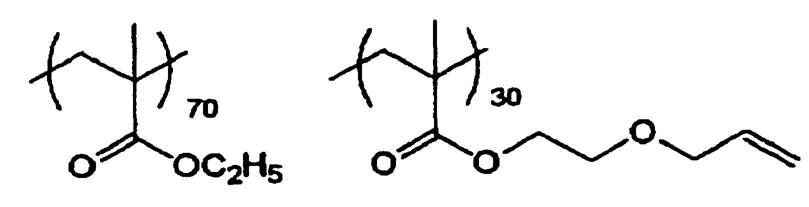

### 1-3. Manufacture of Lithographic Printing Plate Precursor (3)

Lithographic printing plate precursor (3) for use in Examples 17 to 19 was prepared in the same manner as in the preparation of lithographic printing plate precursor (1) except that image-recording layer coating solution (3) having the composition shown below was used in place of image- recording layer coating solution (1).

The image-recording layer coating solution (3) was obtained by blending and stirring just before coating the following photosensitive solution (2) and microcapsule solution (2).

| Photosensitive solution (2): | |
|---|---|
| Polymerization initiator (1) above | 0.20 g |
| Sensitizer (1) shown below | 1.00 g |
| Binder polymer (2) above (average molecular weight: 80,000) | 3.00 g |
| Polymerizable compound Aronix M315, manufactured by TOAGOSEI CO., LTD. | 6.20 g |
| Leuco Crystal Violet | 3.00 g |
| Thermal polymerization inhibitor (N-nitrosophenylhydroxylamine aluminum salt) | 0.10 g |
| Fluorine surfactant (1) shown above | 0.10 g |
| Methyl ethyl ketone | 35.00 g |
| 1-Methoxy-2-propanol | 35.00 g |
| | |

| Microcapsule solution (2): | |
|---|---|
| Microcapsule synthesized as follows | 10.00 g |
| Water | 10.00 g |

### Sensitizer (1)

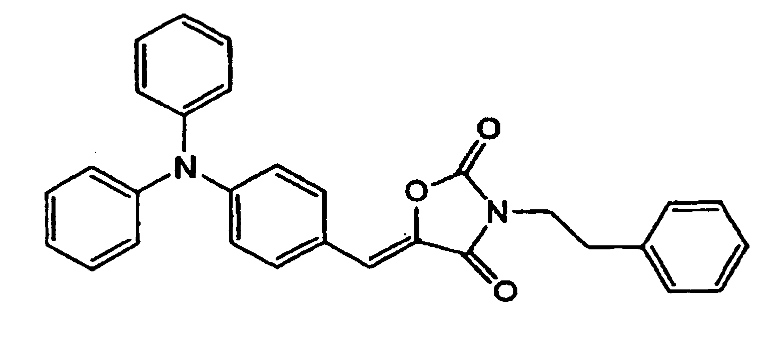

### Synthesis of microcapsule (2):

As the oil phase component, 10 g of the addition product of trimethylolpropane and xylene diisocyanate (Takenate D-110N, manufactured by Mitsui Takeda Chemicals Inc.), 3.15 g of pentaerythritol triacrylate (SR444, manufactured by Nippon Kayaku Co., Ltd.), 1 g of 3-(N,N-diethylamino)-6- methyl-7-anilinofluoran (ODB, manufactured by YAMAMOTO CHEMICALS INC.), and 0.1 g of Pionin A-41C (manufactured by Takemoto Oil & Fat) were dissolved in 17 g of ethyl acetate. As the aqueous phase component, 40 g of a 4 mass% aqueous solution of PVA-205 was prepared. The oil phase component and the aqueous phase component were mixed, and emulsified with a homogenizer at 12,000 rpm for 10 minutes. The obtained emulsified product was added to 25 g of distilled water, stirred at room temperature for 30 minutes, and then stirred at 40°C for 3 hours. The concentration of the solids content of the obtained microcapsule solution (1) was diluted to reach 20 mass% with distilled water. The average particle size was 0.25 µm.

### 2. Execution of lithographic printing method

### EXAMPLES 1 TO 23 AND COMPARATIVE EXAMPLES 1 AND 2

The obtained lithographic printing plate precursors (1) and (2) were subjected to exposure with Trendsetter 3244VX (manufactured by Creo Products Incorporated) loading a water-cooling type 40 W infrared semiconductor laser on the conditions of output of 9 W, external drum rotating speed of 210 rpm, and resolution of 2,400 dpi, so that the exposure image contained a fine line chart.

The obtained lithographic printing plate precursor (3) was subjected to exposure with 375 nm semiconductor laser on the conditions of output of 2 mW, external drum having a peripheral length of 900 mm, rotating speed of 800 rpm, and resolution of 2,400 dpi. The exposure image also contained a fine line chard.

The exposed printing precursor was mounted on the plate cylinder of a printing press having a water supply apparatus shown in Table 1 without performing development. Ecolite-2 (manufactured by Fuji Photo Film Co., Ltd.)/water = 2/98 (by volume) as a fountain solution and TRANS-G (N) Chinese ink (manufactured by Dainippon Ink and Chemicals Inc.) were prepared in the printing press.

By the water supply methods (direct supply or indirect supply), magnitude of oscillation of each roller, the slip ratio of each roller and the water application roller, the slip ratio of the plate surface and the water application roller as shown in Table 1, the printing press was operated at 3,000 rotation an hour to supply the fountain solution to the plate surface 10 rotations (rotary number of plate cylinder) with the water application roller, to supply ink to the plate surface 3 rotations (ditto) with the ink application roller, and then printing was begun by impression of inks while increasing the printing speed and 500 sheets of printed paper were obtained.

Adhesion of the removed components by development on the water supply rollers and on-press developability in the lithographic printing method of the invention were evaluated as follows.

### (1) Adhesion of removed components by development on water supply rollers

After printing, the ink on the ink rollers and water supply rollers was washed with ordinary doctor blades and washing oil. The residual state of the removed components by development on each roller of the water supply rollers after washing was visually observed and evaluated according to the following criteria. The results obtained are shown in Table 2.
Criteria of evaluation of adhered components removed by development:
A: Adhesion of development-removal components was not at all after washing with washing oil.
B: Adhesion was observed a little after washing, but the components could be removed by washing with ABC safety blanket roller cleaner (manufactured by OPENSHAW LIMITED), practicable level.
C: Adhesion was a little left even after washing with ABC safety blanket roller cleaner, impracticable level.
D: A great amount of adhesion was left after washing with ABC safety blanket roller cleaner.

### (2) On-press developability

With respect to the above printed papers, the number of sheets required from the start of printing until the printed matter free from ink soiling on the non-image area is obtained are counted as loss sheets of papers required by on-press development, and this is evaluated as on-press developability. The results obtained are shown in Table 2.

**TABLE 1**

| Example No. | Lithographic Printing Plate Precursor | Mechanism of Water Supply | | | | | | | | |
|---|---|---|---|---|---|---|---|---|---|---|
| | | Apparatus | Method (direct/ indirect) | Magnitude of oscillation of each roller | | | Slip Ratio of Water Application Roller and Each roller (%) | | | Slip Ratio of Printing Plate Surface and Water Application Roller (%) |
| | | | | 22* | 24* | 40* | 22* | 24* | 40* | |
| Example 1 | (1) | A | direct | 8 mm | - | - | 0 | - | - | 0 |
| Example 2 | (1) | A | direct | 8 mm | - | - | 5 | - | - | 0 |
| Example 3 | (1) | A | direct | 8 mm | - | - | 10 | - | - | 5 |
| Example 4 | (1) | B | direct | 8 mm | 0 mm | 0 mm | 0 | 0 | 0 | 0 |
| Example 5 | (1) | B | direct | 0 mm | 4 mm | 0 mm | 0 | 0 | 0 | 0 |
| Example 6 | (1) | B | direct | 8 mm | 4 mm | 8 mm | 0 | 0 | 0 | 0 |
| Example 7 | (1) | B | direct | 8 mm | 4 mm | 8 mm | 0 | 5 | 0 | 0 |
| Example 8 | (1) | B | direct | 8 mm | 4 mm | 8 mm | 0 | 5 | 0 | 5 |
| Example 9 | (1) | C | direct | 8 mm | 0 mm | - | 0 | 0 | - | 0 |
| Example 10 | (1) | C | direct | 0 mm | 6 mm | - | 0 | 0 | - | 0 |
| Example 11 | (1) | C | direct | 0 mm | 6 mm | - | 5 | 0 | - | 0 |
| Example 12 | (1) | C | direct | 8 mm | 6 mm | - | 0 | 0 | - | 5 |
| Example 13 | (1) | C | direct | 8 mm | 6 mm | - | 0 | 5 | - | 5 |
| Example 14 | (2) | A | direct | 8 mm | - | - | 10 | - | - | 5 |
| Example 15 | (2) | B | direct | 8 mm | 4 mm | 8 mm | 0 | 5 | 0 | 5 |
| Example 16 | (2) | C | direct | 8 mm | 15 mm | - | 0 | 5 | - | 5 |
| Example 17 | (3) | A | direct | 8 mm | - | - | 10 | - | - | 5 |
| Example 18 | (3) | B | direct | 8 mm | 4 mm | 8 mm | 0 | 5 | 0 | 5 |
| Example 19 | (3) | C | direct | 8 mm | 15 mm | - | 0 | 5 | - | 5 |
| Example 20 | (1) | C | direct | 0 mm | 15 mm | - | 0 | 0 | - | 5 |
| Example 21 | (1) | C | direct | 0 mm | 15 mm | - | 5 | 0 | - | 0 |
| Example 22 | (1) | C | direct | 8 mm | 15 mm | - | 0 | 0 | - | 5 |
| Example 23 | (1) | C | direct | 8 mm | 15 mm | - | 0 | 5 | - | 5 |
| Comparative Example 1 | (1) | A | indirect | 8 mm | - | - | 0 | - | - | 0 |
| Comparative Example 2 | (1) | C | direct | 0 mm | 0 mm | - | 0 | 0 | - | 0 |

| | | | | | | | | | | |
|---|---|---|---|---|---|---|---|---|---|---|
| The symbols of water supply mechanism in Table 1 are as follows. A: Epic Delta water supply apparatus B: Alcolor water supply apparatus C: Komorimatic water supply apparatus 22*, 24* and 40*: Corresponding to roller numbers in Fig. 1 to 3 | | | | | | | | | | |

**TABLE 2**

| Example No. | Adhesion of Development-Removal Components on Water Application Rollers | On-Press Developability |
|---|---|---|
| Example 1 | B | 25 |
| Example 2 | A | 20 |
| Example 3 | A | 15 |
| Example 4 | B | 25 |
| Example 5 | B | 25 |
| Example 6 | A | 20 |
| Example 7 | A | 20 |
| Example 8 | A | 15 |
| Example 9 | B | 25 |
| Example 10 | B | 25 |
| Example 11 | A | 20 |
| Example 12 | A | 20 |
| Example 13 | A | 15 |
| Example 14 | A | 20 |
| Example 15 | A | 20 |
| Example 16 | A | 20 |
| Example 17 | A | 15 |
| Example 18 | A | 15 |
| Example 19 | A | 15 |
| Example 20 | A | 15 |
| Example 21 | A | 20 |
| Example 22 | A | 10 |
| Example 23 | A | 10 |
| Comparative Example 1 | A | 85 |
| Comparative Example 2 | D | 50 |

As can be seen from the results in Table 2, in the lithographic printing method according to the invention, the contamination of water supply rollers by the components removed by on-press development is reduced and the reduction of paper loss by initial printing out can be achieved, by which the workability of printing and productivity can be heightened.

The present invention can provide a lithographic printing method using an on-press development type printing plate material, by which the contamination of water supply rollers by the components removed by on-press development is little, the amount of paper loss of initial printing out is little, so that the time required until a printed matter free from contamination is obtained is short, and so workability and productivity are extremely high.

## Claims

1. A lithographic printing method comprising:
(i) a process of one of (i-1) imagewise exposing a lithographic printing plate precursor comprising a support and an image-recording layer capable of being removed with at least one of a fountain solution and a printing ink, and mounting the exposed printing plate precursor on a plate cylinder of a printing press; and (i-2) mounting the lithographic printing plate precursor on a plate cylinder of a printing press and imagewise exposing the lithographic printing plate precursor;
(ii) a process of removing an unexposed area of the image-recording layer by directly supplying a fountain solution on the exposed lithographic printing plate precursor with a water application roller of the printing press; and
(iii) a process of printing,
wherein the printing press comprises a water supply apparatus including a water application roller and at least one roller in contact with the water application roller, at least one of said at least one roller being an oscillating roller.

2. The lithographic printing method as claimed in claim 1,
wherein the image-recording layer comprises:
(A) an infrared absorber;
(B) a polymerization initiator;
(C) a polymerizable compound; and
(D) a lipophilic binder polymer, and
wherein an exposure light source is an infrared laser.

3. The lithographic printing method as claimed in claim 1,
wherein the image-recording layer comprises:
(B) a polymerization initiator;
(C) a polymerizable compound; and
(D) a lipophilic binder polymer, and
wherein the image-recording layer has photosensitivity in the range of a wavelength of from 250 to 420 nm, and an exposure light source is an ultraviolet laser.

4. The lithographic printing method as claimed in claim 1,
wherein the water application roller is in contact with at least one roller having a surface linear velocity different from that of the water application roller.

5. The lithographic printing method as claimed in claim 1,
wherein a surface linear velocity of the water application roller is different from a surface linear velocity of the plate cylinder.

6. The lithographic printing method as claimed in claim 1,
wherein an oscillation width of said at least one oscillating roller adjacent to the water application roller is 10 mm or more.

7. The lithographic printing method as claimed in claim 2,
wherein an oscillation width of said at least one oscillating roller adjacent to the water application roller is 10 mm or more.

8. The lithographic printing method as claimed in claim 1,
wherein the image-recording layer comprises microcapsules or microgel.

## Patentansprüche

1. Lithografisches Druckverfahren, umfassend
(i) ein Verfahren, ausgewählt aus (i-1) dem bildweisen Belichten eines lithografischen Druckplattenvorläufers, umfassend einen Träger und eine Bildaufzeichnungsschicht, die durch zumindest eines von einem Feuchtmittel und einer Drucktinte entfernt werden kann, und Befestigen des belichteten Druckplattenvorläufers auf einem Plattenzylinder einer Druckpresse, und (i-2) Befestigen des lithografischen Druckplattenvorläufers auf einem Plattenzylinder einer Druckpresse und bildweises Belichten des lithografischen Druckplattenvorläufers,
(ii) ein Verfahren zum Entfernen der nichtbelichteten Fläche der Bildaufzeichnungsschicht durch direktes Zuführen eines Feuchtmittels zu dem belichteten lithografischen Druckplattenvorläufer mit einer Wasserauftragungswalze der Druckpresse; und
(iii) ein Verfahren zum Drucken,
worin die Druckpresse eine Wasserzuführanlage, umfassend eine Wasserauftragungswalze und zumindest eine Walze in Kontakt mit der Wasserauftragungswalze umfasst, wobei zumindest eine der zumindest einen Walze eine Oszillationswalze ist.

2. Lithografisches Druckverfahren nach Anspruch 1, worin die Bildaufzeichnungsschicht umfasst:
(A) einen Infrarotabsorber,
(B) einen Polymerisationsinitiator,
(C) eine polymerisierbare Verbindung, und
(D) ein lipophiles Bindepolymer, und
worin die Belichtungslichtquelle ein Infrarotlaser ist.

3. Lithografisches Druckverfahren nach Anspruch 1, worin die Bildaufzeichnungsschicht umfasst:
(B) einen Polymerisationsinitiator,
(C) eine polymerisierbare Verbindung und
(D) ein lipophiles Bindepolymer, und
worin die Bildaufzeichnungsschicht eine Lichtempfindlichkeit im Bereich einer Wellenlänge von 250 bis 420 nm aufweist und eine Belichtungslichtquelle ein Ultraviolettlaser ist.

4. Lithografisches Druckverfahren nach Anspruch 1, worin die Wasserauftragungswalze in Kontakt mit zumindest einer Walze mit einer linearen Oberflächengeschwindigkeit ist, die von der der Wasserauftragungswalze verschieden ist.

5. Lithografisches Druckverfahren nach Anspruch 1, worin die lineare Oberflächengeschwindigkeit der Wasserauftragungswalze von der linearen Oberflächengeschwindigkeit des Plattenzylinders verschieden ist.

6. Lithografisches Druckverfahren nach Anspruch 1, worin die Oszillationsbreite der zumindest einen Oszillationswalze neben der Wasserauftragungswalze 10 mm oder mehr ist.

7. Lithografisches Druckverfahren nach Anspruch 2, worin die Oszillationsbreite der zumindest einen Oszillationswalze neben der Wasserauftragungswalze 10 mm oder mehr ist.

8. Lithografisches Druckverfahren nach Anspruch 1, worin die Bildaufzeichnungsschicht Mikrokapseln oder ein Mikrogel umfasst.

## Revendications

1. Procédé d'impression lithographique comprenant :
(i) un processus de l'un parmi (i-1) l'exposition image par image d'un précurseur de plaque d'impression lithographique comprenant un support et une couche d'enregistrement d'image capable d'être enlevée avec au moins l'une parmi une solution de mouillage et une encre d'impression, et le montage du précurseur de plaque d'impression exposé sur un cylindre porte-plaque d'une presse d'impression ; et (i-2) le montage du précurseur de plaque d'impression lithographique sur un cylindre porte-plaque d'une presse d'impression et l'exposition image par image du précurseur de plaque d'impression lithographique ;
(ii) un consistant à enlever une région non exposée de la couche d'enregistrement d'image par apport direct d'une solution de mouillage sur le précurseur de plaque d'impression lithographique exposé avec un rouleau d'application d'eau de la presse d'impression ; et
(iii) un procesuss d'impression,
dans lequel la presse d'impression comprend un appareil d'alimentation en eau incluant un rouleau d'application d'eau et au moins un rouleau en contact avec le rouleau d'application d'eau, au moins l'un dudit au moins un rouleau étant un rouleau oscillant.

2. Procédé d'impression lithographique tel que revendiqué dans la revendication 1,
dans lequel la couche d'enregistrement d'image comprend :
(A) un absorbeur d'infrarouge ;
(B) un amorceur de polymérisation;
(C) un composé polymérisable ; et
(D) un polymère de liaison lipophile, et
dans lequel une source de lumière d'exposition est un laser infrarouge.

3. Procédé d'impression lithographique tel que revendiqué dans la revendication 1,
dans lequel la couche d'enregistrement d'image comprend :
(B) un amorceur de polymérisation ;
(C) un composé polymérisable ; et
(D) un polymère de liaison lipophile, et
dans lequel la couche d'enregistrement d'image a une photosensibilité située dans la plage de longueurs d'onde de 250 à 420 nm, et une source de lumière d'exposition est un laser ultraviolet.

4. Procédé d'impression lithographique tel que revendiqué dans la revendication 1,
dans lequel le rouleau d'application d'eau est en contact avec au moins un rouleau ayant une vitesse linéaire de surface différente de celle du rouleau d'application d'eau.

5. Procédé d'impression lithographique tel que revendiqué dans la revendication 1,
dans lequel une vitesse linéaire de surface du rouleau d'application d'eau est différente d'une vitesse linéaire de surface du cylindre porte-plaque.

6. Procédé d'impression lithographique tel que revendiqué dans la revendication 1,
dans lequel une largeur d'oscillation dudit au moins un rouleau oscillant adjacent au rouleau d'application d'eau est 10 mm ou davantage.

7. Procédé d'impression lithographique tel que revendiqué dans la revendication 2,
dans lequel une largeur d'oscillation dudit au moins un rouleau oscillant adjacent au rouleau d'application d'eau est 10 mm ou davantage.

8. Procédé d'impression lithographique tel que revendiqué dans la revendication 1,
dans lequel la couche d'enregistrement d'image comprend des microcapsules ou un microgel.
